# EUROPÄISCHE PATENTSCHRIFT

(11) **EP 0 548 863 B1**
(45) Veröffentlichungstag und Bekanntmachung des Hinweises auf die Patenterteilung: **26.03.1997**
(21) Anmeldenummer: 92121662.8
(22) Anmeldetag: 19.12.1992
(51) Int. Cl.: H01L 31/062, H01L 31/0236, H01L 31/0224

(54) **Verfahren zur Herstellung einer Solarzelle sowie Solarzelle**
Method of fabricating a solar cell and solar cell
Procédé pour la fabrication d'une cellule solaire et cellule solaire

(30) Priorität: 27.12.1991 DE 4143083; 27.12.1991 DE 4143084
(43) Veröffentlichungstag der Anmeldung: 30.06.1993
(73) Patentinhaber: Hezel, Rudolf, Dr., D-81245 München (DE)
(72) Erfinder: Hezel, Rudolf, Dr., D-81245 München (DE)
(74) Vertreter: Stoffregen, Hans-Herbert, Dr. Dipl.-Phys.

(56) Entgegenhaltungen:
- EP-A- 0 286 917
- 19TH IEEE PHOTOVOLTAIC SPECIALISTS CONFERENCE 4. Mai 1987, NEW ORLEANS, LOUISIANA, USA Seiten 1424 - 1429 D.B. BICKLER ET AL. 'The economic payoff for a state -of-the-art high efficiency flat-plate crystalline silicon solar cell technology'
- APPLIED PHYSICS LETTERS. Bd. 55, Nr. 13, 25. September 1989, NEW YORK US Seiten 1363 - 1365 A.W. BLAKERS ET AL. '22.8% efficient silicon solar cell'
- IEEE ELECTRON DEVICE LETTERS. Bd. 11, Nr. 1, Januar 1990, NEW YORK US Seiten 6 - 8 A. CUEVAS ET AL. '26% efficient point-junction concentrator solar cells with a front metal grid'
- 5TH INTERNATIONAL PHOTOVOLTAIC SCIENCE AND ENGINEERING CONFERENCE 26. November 1990, KYOTO, JAPAN Seiten 701 - 704 R. HEZEL ET AL. 'Advantages of textured multicrystalline silicon for MIS inversion layer solar cells'
- 5TH INTERNATIONAL PHOTOVOLTAIC SCIENCE AND ENGINEERING CONFERENCE 26. November 1990, KYOTO, JAPAN Seiten 533 - 536 H. ITOH ET AL. 'New a-Si solar cell with a V-grooved glass substrate'
- 14TH IEEE PHOTOVOLTAIC SPECIALISTS CONFERENCE 7. Januar 1980, SAN DIEGO, CALIFORNIA, USA Seiten 783 - 786 T.G. SPARKS ET AL. 'A reactive plasma process for forming metal grid patterns in solar cell antireflection coatings'
- APPLIED PHYSICS LETTERS. Bd. 41, Nr. 7, 1. Oktober 1982, NEW YORK US Seiten 649 - 651 P.G. BORDEN ET AL. 'Silicon solar cell with a novel low resistance emitter structure'

## Beschreibung

Die Erfindung bezieht sich auf ein Verfahren zur Herstellung einer Solarzelle umfassend ein Halbleitersubstrat, in welchem durch einfallende Strahlungsenergie Ladungsträger erzeugt werden, sowie elektrisch leitende Kontakte zum Ableiten von Ladungsträgern, wobei zur Herstellung der Solarzelle
- auf zumindest einer Halbleitersubstratfläche Erhebungen ausgebildet werden,
- nach Ausbildung der Erhebungen die Halbleitersubstratfläche ganzflächig oder weitgehend ganzflächig mit Passivierungsmaterial abgedeckt wird,
- von den Erhebungen zumindest teilweise auf diesen vorhandenes Passivierungsmaterial entfernt wird und
- zumindest auf so freigelegte Bereiche der Erhebungen mittelbar oder unmittelbar sowie bereichsweise auf von den Erhebungen ausgehenden Flanken vorhandenem Passivierungsmaterial die elektrisch leitenden Kontakte bildendes Material angeordnet wird.

Auch bezieht sich die Erfindung auf eine Solarzelle umfassend ein Halbleitersubstrat, in welchem durch einfallende Strahlungsenergie Ladungsträger erzeugbar sind, die durch ein elektrisches Feld trennbar und sodann über elektrisch leitende Kontakte ableitbar sind, wobei
- zumindest auf einer Halbleitersubstratfläche Flanken aufweisende Erhebungen versehen mit Ladungsträger ableitenden elektrisch leitenden Kontakten ausgebildet sind,
- die Halbleitersubstratfläche zumindest im Bereich zwischen den Kontakten mit einem eine Passivierungsschicht bildenden Passivierungsmaterial abgedeckt ist und
- die Kontakte auf den zuvor von Passivierungsschichtmaterial abgedeckten und sodann von diesem und gegebenenfalls von Halbleitermaterial entfernten Spitzenbereichen der Erhebungen angeordnet sind und sich zumindest bereichsweise über Passivierungsmaterial entlang von Flanken erstrecken.

Schließlich nimmt die Erfindung Bezug auf eine Solarzelle mit einem Halbleitersubstrat, in welchem durch einfallende Strahlungsenergie Ladungsträger erzeugt werden, die von auf einer Seite des Halbleitersubstrats angeordneten ersten und zweiten Minoritäts- bzw. Majoritätsträger sammelnden Kontakten ableitbar sind.

Wesentliche Voraussetzungen zur Erzielung sehr hoher Wirkungsgrade bei photovoltaischen Solarzellen sind neben einer optimalen Einkopplung des Lichtes durch geeignete Oberflächenstrukturierung und Kontaktanordnung vor allem eine möglichst geringe Kontaktfläche und eine sehr gute Oberflächenpassivierung im aktiven Gebiet des Halbleiters. Hierdurch werden Kurzschlußstrom und über die Erniedrigung des Sättigungssperrstroms sowohl die Leerlaufspannung als auch der Füllfaktor der Solarzelle erhöht. Die gegenwärtig höchsten Laborwirkungsgrade (nahe 24%) für mit dotiertem pn-Übergang hergestellte Siliziumsolarzellen werden erreicht durch eine aufwendige photolithographisch erzeugte Oberflächenstruktur, Hochtemperaturpassivierung mittels einer thermischen Siliziumdioxidschicht, in welche wiederum durch Photolithographie und Ätzung kleinste Öffnungen für die zur Ableitung der Ladungsträger erforderlichen Metallkontakte eingebracht werden (M.A. Green, S.R. Wenham, J Zhao, J. Zolper and A.W. Blakers, Proceedings 21.IEEE Photovoltaic Specialists Conference, S. 207, 1990). Eine Doppeldiffusion im Kontaktbereich trägt zur weiteren Verminderung des Sättigungssperrstroms bei. Der komplexe Herstellungsprozeß dürfte jedoch für eine kostengünstige Massenproduktion terrestrischer Solarzellen nur bedingt durchführbar sein.

In der Literaturstelle "R. Hezel, W. Hoffmann and K. Jaeger, Proceedings 10th European Photovoltaic Solar Energy Conference, Seite 511, Lissabon 1991" wird eine hervorzuhebende MIS Inversionsschichtsolarzelle beschrieben, die zur Senkung der Herstellungskosten bei hohem Wirkungsgrad führt. Die Herstellung kann aufgrund des induzierten pn-Übergangs durch einfache Niedertemperaturprozesse erfolgen und ist dadurch vor allem für sehr dünne, auch beidseitig lichtempfindliche (bifacial) Ausführungsformen geeignet. Um den Wirkungsgrad der Solarzelle noch weiter zu erhöhen, ist u. a. neben der Verringerung der Kontaktfläche eine drastische Verbesserung der Oberflächenpassivierung erforderlich.

Es ist bekannt, daß die Qualität der Siliziumoberflächenpassivierung durch die Abscheidung einer Plasmasiliziumnitridschicht bei etwa 450°C und damit der Wirkungsgrad erheblich gesteigert werden kann (W. Bauch and R. Hezel, Proceedings 9th E.C. Photovoltaic Solar Energy Conference, S. 390, Freiburg 1989). Hierzu sind jedoch zur Erzeugung von Öffnungen in der Passivierschicht und zur Definition des Kontaktgitters zwei Photolithographieschritte erforderlich, die sich in einer Massenproduktion und bei großen Solarzellenflächen nur sehr schwer kostengünstig durchführen lassen.

Aus IEEE Electron Device Letters, Bd. 11, Nr. 1, Januar 1990, New York, US, Seiten 6 - 8, A. Cuevas et al ist eine Punktkontakt-Konzentratorsolarzelle bekannt, bei der eine Strukturierung auf photolithographischem Wege erreicht wird. Die Solarzellenoberfläche weist eine Vielzahl von Erhebungen auf, von denen nur einige mit einem elektrisch leitenden Material zur Bildung eines Frontkontaktes bereichsweise abgedeckt sind. Das elektrisch leitende Material erstreckt sich auf im Schnitt eine V-Form aufweisenden stellenweise freigelegten Bereichen von Halbleitermaterial sowie bereichsweise über eine Oxidschicht als Passivierung. Das elektrisch leitende Material erstreckt sich entlang beider Flanken der Erhebungen. Durch die photolithographischen Verfahrensschritte bedingt ist die Herstellung entsprechender Zellen sehr aufwendig und unter anderem wegen der hohen Herstellungskosten für eine breite kommerzielle Anwendung ungeeignet.

Eine Solarzelle mit streifenförmigen Frontkontakten ist aus 19th IEEE Photovoltaic Specialists Conference, 4, Mai 1987, New Orleans, Louisiana, USA, Seiten 1424 - 1429, D.B. Bickler et al. bekannt. Die Kontakte erstrecken sich ausschließlich auf plateauartig verlaufenden Bereichen des Halbleitersubstrats, die bereichsweise mit einer Oxidschicht abgedeckt sind. Zur Herstellung der Struktur sind eine Vielzahl von photolithographischen Verfahrensschritten erforderlich.

Sowohl die zuvor als auch die zuletzt beschriebenen Solarzellen erfordern eine aufwendige Masken-, Justier- und Ätztechnik.

Ätzverfahren und Maskentechnik sind gleichfalls bei einer aus Applied Physics Letters, Bd. 55, Nr. 13, 25. September 1989, New York, USA, Seiten 1363 - 1365, A.W. Blakers et al. bekannten Solarzelle erforderlich, bei der die Frontkontakte linienförmig auf einer Durchbrechungen aufweisenden Oxidschicht angeordnet sind.

Bekannt ist es auch, eine Frontseite einer MIS-Solarzelle durch anisotropes Ätzen zu strukturieren (5th International Photovoltaic Science and Engineering Conference, 26. November 1990, Kyoto, Japan, Seiten 701 - 704, R. Hezel et al.

Bei der aus 5th International Photovoltaic Science and Engineering Conference, 26. November 1990, Kyoto, Japan, Seiten 533 - 536, H. Itoh et al. bekannten Solarzelle wird ein a-Si-Solarzellensubstrat auf einem vorstrukturierten Glasträger aufgetragen.

In Applied Physics Letters, Bd. 41, Nr. 7, 1. Oktober 1982, New York, USA, Seiten 649 - 651, P.G. Borden et al. wird eine Si-Solarzelle beschrieben, bei der ein durch Ätzen und Photolithographie strukturierter Frontkontakt eine durch CVD-abgeschiedene Oxidschicht überdeckt.

Durch anisotropes Ätzen wird nach 14th IEEE Photovoltaic Specialists Conference, 7. Januar 1980, San Diego, California, USA, Seiten 783 - 786, T.G. Sparks et al. eine Oberflächenstruktur einer Solarzelle erzeugt, auf der durch Plasmaätzen und mittels mechanischer Masken Frontkontakte aufgebracht werden.

Der Erfindung liegt u. a. das Problem zugrunde, mittels einfacher Technologie und gegebenenfalls unter Anwendung großflächiger und insbesondere sehr einfacher Bearbeitungsmethoden sowohl durch Hochtemperatur- als auch insbesondere durch Niedertemperaturprozesse sehr effiziente Solarzellen herzustellen. Dabei soll eine Anwendbarkeit für alle Arten von Halbleitern, Element- und Verbindungshalbleitern, sowohl in einkristalliner Form beliebiger Oberflächenorientierung, in polykristalliner Form jeglicher Korngröße und Orientierung als auch im amorphen Zustand, in selbsttragender (dicker) Ausführung als auch mit Dünnfilmhalbleitern auf Fremdsubstrat möglich sein.

Auch ist es Problem der Erfindung, eine einfach zu realisierende Anordnung der ersten und zweiten Kontakte auf einer Seite der Solarzelle aufzuzeigen, die insbesondere für großflächige, nicht konzentrierende Systeme vorteilhaft eingesetzt werden kann. Dabei soll eine Realisierung sowohl auf durch Diffusion erzeugten pn-Übergängen als auch auf der Induzierung eines elektrischen Feldes durch ein Metall oder durch oberflächliche Isolatorladungen basieren können. Es soll zusätzlich auch das durch eine rückseitige Doppel-Kontaktgitterstruktur einfallende Licht ausgenützt und schließlich eine einfache doppelseitig beleuchtbare und doppelseitig Minoritätsladungsträger sammelnde Solarzelle zur Verfügung gestellt werden. Letztere dient sowohl zur bestmöglichen Ausnützung des Umgebungsstreulichtes als auch zur sehr effektiven Sammlung der lichterzeugten Ladungsträger insbesondere bei Vorliegen eines billigeren Halbleitersubstrates mit reduzierter Diffusionslänge der Minoritätsladungsträger.

Das Problem wird verfahrensmäßig im wesentlichen dadurch gelöst,
- daß die Erhebungen maskierungsfrei durch mechanisches Abtragen oder Abätzen von Halbleitermaterial ausgebildet werden und
- daß zumindest das Passivierungsmaterial von den Erhebungen derart abgetragen wird, daß ein plateauartiger Bereich ausgebildet wird, von dessen freier oberen Fläche die Flanken ausgehen und in dem Halbleitermaterial freigelegt verläuft.

Dabei wird vorzugsweise das die elektrisch leitenden Kontakte bildende Material ohne Verwendung einer gesonderten Maske auf dem plateauartigen Bereich der Erhebungen sowie auf zumindest einer Flanke einer jeden mit dem die elektrisch leitenden Kontakte bildenden Material versehenen Erhebung aufgebracht.

Ferner wird das eingangs gestellte Problem auch durch eine Solarzelle gelöst, die sich dadurch auszeichnet, daß die Passivierungsschicht im Bereich der Erhebung zumindest bereichsweise einen plateauartig ausgebildeten Bereich aufweist, von dem die Flanken ausgehen und in dem Halbleitersubstratmaterial oder eine auf diesem angeordnete Schicht freigelegt verläuft, und daß das den elektrisch leitenden Kontakt bildende Material sich auf dem plateauartigen Bereich und entlang von zumindest einer von diesem ausgehenden Flanke erstreckt.

Lösungen der weiteren Problemstellungen sehen eine Solarzelle mit einem Halbleitersubstrat vor, in welchem durch einfallende Strahlungsenergie Ladungsträger erzeugt werden, die von auf einer Seite des Halbleitersubstrats angeordneten ersten und zweiten Minoritäts- bzw. Majoritätsträger sammelnden Kontakten ableitbar sind, die sich einerseits dadurch auszeichnet, daß die ersten und zweiten Kontakte auf einer Erhebungen aufweisenden Halbleitersubstratfläche angeordnet sind, daß die ersten und zweiten Kontakte zumindest bereichsweise auf zuvor mit Passivierungsmaterial abgedeckten und sodann von diesem freigelegten Abschnitten der Erhebungen unmittelbar oder auf einer Isolatorschicht (214) oder auf einer oberflächig dotierten Schicht des Halbleitermaterials angeordnet sind .

Andererseits zeichnet sich eine entsprechende Solarzelle dadurch aus, daß sich die ersten elektrisch leitenden Kontakte oder von diesen gebildete Bereiche ganzflächig oder im wesentlichen ganzflächig zwischen den zweiten elektrisch leitenden Kontakten erstrecken und die ersten und zweiten elektrischen Kontakte auf in ihren Höhen unterschiedlichen Bereichen des Halbleitersubstrats verlaufen.

Dabei sind die ersten und zweiten elektrisch leitenden Kontakte vorzugsweise Ohmsche Kontakte und MIS-Kontakte.

Jeweilige Ausgestaltungen ergeben sich sowohl aus den Unteransprüchen als auch aus der gesamten Erläuterung der Erfindung.

Durch die erfindungsgemäße Lehre können ohne aufwendige Maskentechniken und vorwiegend durch Selbstjustierung, also ohne Maskierung, zusammenhängende Kontaktfingersysteme sehr kleiner Berührungsfläche mit dem Halbleiter, großem Leiterquerschnitt und trotzdem geringer Abschattung erzeugt werden, die zur Ableitung von Minoritäts- oder von Majoritätsladungsträgern auf der Vorder- und/oder Rückseite der Solarzelle dienen können.

Ein weiteres wesentliches Merkmal des Erfindungsgedankens ist es, daß die aktive Fläche zwischen den ein Kontaktgitter bildenden Kontakten von einer durchsichtigen Schicht überzogen ist, die die Oberflächenrekombinationsgeschwindigkeit des Halbleiters minimiert und gleichzeitig als Antireflexionsschicht dient. Diese Schicht wird zur Erzielung optimaler Passiviereigenschaften vor der Kontaktherstellung und damit ohne jegliche Einschränkungen bezüglich Temperatur und Dauer des Prozesses aufgebracht. Die Auswahl der anwendbaren Schichten ist damit nicht eingeschränkt.

Es kommt der bei hohen Temperaturen (> 500°C, vorzugsweise > 700°C) im Fall des Siliziums durch Aufoxidation erzeugte und als thermisches Siliziumoxid bezeichnete Film infrage, wie er bisher für Hocheffizienzsolarzellen verwendet wird. Aber auch auf andere Art, wie beispielsweise durch chemische Dampfphasenabscheidung ("CVD"), vorzugsweise plasmaunterstützt, können auf dem Halbleiter Schichten wie Siliziumnitrid, Siliziumoxynitrid, Aluminiumoxid erzeugt werden. Dabei soll für die Oberflächen- und Volumenpassivierung des Halbleiters der günstige Einfluß von in die Schicht eingebautem bzw. während der Abscheidereaktion entstehendem hochaktiven Wasserstoff ausgenützt werden.

Auch ist für die Passivierung der Einbau von elektrischen Ladungen in die Passivierschicht nahe der Halbleiteroberfläche von Vorteil, wodurch im Halbleiter Inversion oder Akkumulation, je nach dem Vorzeichen der Ladungen, erzeugt wird (ladungsinduzierte Passivierung). Zur Erzielung einer möglichst niedrigen Oberflächenzustandsdichte bei niedrigen Herstelltemperaturen hat sich unter Ausnutzung von Wasserstoffeinbau und positiven Isolatorladungen das durch Plasmaunterstützung im CVD-Verfahren bei Temperaturen zwischen 300°C und 500°C abgeschiedene bzw. getemperte Siliziumnitrid als sehr vorteilhaft erwiesen.

Ein Grundgedanke der vorliegenden Erfindung besteht darin, die Halbleiteroberfläche mit einer Struktur aus parallel verlaufenden Gräben zu versehen, wobei die einzelnen Gräben durch möglichst spitz zulaufende, erhöhte Halbleiterbereiche - den Erhebungen - voneinander getrennt sind. Auf dem so strukturierten Halbleiter wird ganzflächig die Passivierschicht erzeugt, vorzugsweise gemäß zuvor beschriebener Verfahren, wobei diese in gleichmäßiger Dicke die gesamte Oberfläche überzieht. Zur Freilegung der Kontaktbereiche wird die meist gut isolierende Passivierschicht durch möglichst geringes Abtragen der vorzugsweise sich nach oben verjüngenden, erhöhten Halbleiterstege - den Erhebungen - entfernt. Sodann werden durch geeignete Metallisierungsverfahren selektiv die eine Kontaktfingerstruktur bildenden Kontakte aufgebracht. Die Größe der von der Passivierschicht freigelegten Halbleiterfläche und damit der eigentlichen Kontaktfläche kann neben dem beim Erzeugen der Gräben gewählten Furchenabstand im Falle der sich vorzugsweise nach unten verbreiternden Stege auch auf einfache Weise durch die Höhe des Abtrags eingestellt werden.

Dabei wird - abweichend von dem eingangs diskutierten Stand der Technik - grundsätzlich auf jeder Erhebung ein Kontakt aufgebracht.

Die ohne Maskierung mechanisch hergestellten Rinnen zwischen den Vertiefungen weisen dabei vorzugsweise eine Tiefe (Abstand zwischen Rinnenboden und Spitze der Erhebung) zwischen 25 µm und 200 µm auf. Der Abstand zwischen den Erhebungen selbst liegt vorzugsweise zwischen 30 µm und 2000 µm, insbesondere jedoch zwischen 50 µm und 300 µm. Besonders gute Ergebnisse lassen sich erzielen, wenn der Abstand zwischen den Erhebungen zwischen dem 1,5-fachen und dem 10-fachen der Tiefe der Vertiefungen liegt.

Durch die erfindungsgemäße Lehre wird nicht nur die Möglichkeit der einfachen selektiven Entfernung der Passivierschicht und der anschließenden selektiven Aufbringung der Metallkontaktfinger gewährleistet, sondern durch die beschriebene Oberflächenstrukturierung in Form von Gräben oder ähnlichen Vertiefungen wird außerdem noch die Einkopplung des Lichtes in den Halbleiter stark verbessert. Es ergibt sich eine Doppelfunktion der Erhebungen.

Als Metallisierungsverfahren kann ein selbstjustierendes Verfahren wie vorteilhafterweidie Methode des Schrägaufdampfens im Hochvakuum verwendet werden. Hierdurch kann ohne jegliche Maske und Justierung jeweils auf einer Seite der Stege eine relativ dicke und ausgedehnte Metallschicht, auf dem flachen oberflächlichen Kontaktbereich jedoch wegen des geringen Aufdampfwinkels eine dünne und schmale Metallschicht aufgebracht werden. Dadurch wird automatisch die angestrebte kleine Kontaktfläche des Metalls mit dem Halbleiter bei großem Metallquerschnitt und wegen des sehr steilen Flankenbereiches auch eine geringe Lichtabschattung durch die Metallbahnen erreicht. Zusätzlich wird das auf die im Flankenbereich verlaufenden Metallfinger auftreffende Licht noch in die Gräben hineinreflektiert und damit sehr gut ausgenützt.

Beim Schrägaufdampfen schattet jede Erhebung die zugewandte Flanke der folgenden Erhebung ab. Dabei sollte der Einfallswinkel des Aufdampfens vorzugsweise so gewählt sein, daß der Einfallswinkel zu einer Ebene, die von den freien oberen Flächen der Erhebungen aufgespannt wird, im Bereich zwischen 30° und 1° liegt. Durch das Schrägaufdampfen bildet sich auch ein asymmetrischer Kontakt aus, der sich einerseits auf der abgeflachten plateauartigen oberen Fläche der Erhebung, innerhalb der Halbleitermaterial freigelegt wird oder eine auf dieser oder aus dieser gebildeten Schicht verläuft, und andererseits entlang einer der Flanken erstreckt.

Die Breite des plateauartigen Bereichs der Erhebung ist dabei stets größer als die doppelte Dicke der die Oberfläche des Halbleitersubstrats bedeckenden Passivierungsschicht. Die Breite des plateauartigen Bereichs ist jedoch vorzugsweise im Bereich zwischen 200 nm und 10 µm.

Erfindungsgemäß verläuft folglich der weitaus größte Teil der zur Stromableitung dienenden elektrisch leitenden Kontakte wie Metallfinger nicht auf dem Halbleiter, sondern auf der isolierenden Passivierschicht und trägt somit nicht zur Erhöhung des Sättigungssperrstromes bei.

Die Metallisierung kann neben der Schrägaufdampfung im Vakuum auch durch andere Methoden selbstjustierend und ohne Maskierung erfolgen. Elektrolytische Metallabscheidung oder stromloses Metallisieren ("electroless plating") bieten sich besonders an, da die Maskierung automatisch durch die seitlich an den Flanken sich befindliche Passivierschicht erfolgt. Auf den isolierenden Bereichen scheidet sich zunächst kein Metall ab, so daß dieses sich überwiegend auf den freigelegten horizontalen Stegbereichen und schließlich durch seitliches Herauswachsen auch teilweise beidseitig auf den steilen passivierten Flanken befindet und somit eine pilzförmige Form annimmt. Dieses selbstjustierende Metallisierungsverfahren eignet sich besonders für diffundierte, ionenimplantierte oder durch Legieren dotierte Kontaktbereiche.

Ein weiterer sehr geeigneter, selbstjustierender Vorschlag zur Ausbildung der elektrisch leitenden Kontakte sieht vor, die strukturierte Oberfläche nach dem Abtragen der Passivierschicht in eine leitfähige Paste oder in ein Metallbad gezielt einzutauchen ("dip coating"), wobei nur die Stegoberseite mit der freien Halbleiteroberfläche und je nach Eintauchtiefe auch die passivierten Flankenbereiche mit dem Metall bedeckt werden. Der jeweilige Metallfingerquerschnitt wird demnach durch die Eintauchtiefe, Viskosität des Bades etc. bestimmt und kann in weiten Bereichen variiert werden, ohne die Lichtabschattung wesentlich zu beeinflussen. Auch hier erfolgt, ähnlich wie beim Schrägaufdampfen, jedoch auf beiden Seiten des Stegs, eine zusätzliche Reflexion des Lichtes in die Gräben hinein und damit eine sehr vorteilhafte Lichteinkopplung. Auch ist die Möglichkeit gegeben, die Metallpaste im Schleuderverfahren ("spin-on" Verfahren) gezielt einseitig an den Stegspitzen sowie an den flachen horizontalen Stegbereichen aufzubringen.

Die Grabenstruktur mit den erhöhten Zwischenbereichen kann wirtschaftlich vorzugsweise durch großflächig anwendbare, mechanische Methoden ohne jegliche Maskierung ("mechanical grooving") erzeugt werden. Dabei bieten sich großflächig anwendbare Verfahren, beispielsweise das Sägen mit einem oder mehreren parallelen Sägeblättern ("saw dicing"), das Fräsen mit entsprechend strukturierten Werkzeugen aber auch das Gattersägen ("multiblade sawing") an. Letztere besteht aus einer Anordnung von vielen parallelen Metallstreifen, deren Sägequerschnitt beliebige Formen (eckig, rund, abgerundete Ecken etc.) besitzen kann.

Durch die Anordnung der einzelnen Metallblätter und deren Strukturierung können bestimmte Grabenfolgen mit Unterbrechungen der einzelnen Gräben erzeugt werden. Derartige Strukturen können beispielsweise für die Anbringung des Hauptableiters des Stromes ("busbar") bei Solarzellen von Bedeutung sein.

Infolge des geringen Sägeschadens und anderer Vorteile wegen bietet sich für die Oberflächenstrukturierung besonders die Drahtsägetechnik mit Hilfe einer Anordnung paralleler Drähte an ("multiwire sawing"). Diese Methode wurde in den letzten Jahren erfolgreich zum Sägen von Halbleiterblöcken in dünne Scheiben eingeführt. Von Bedeutung ist dabei die Wahl des entsprechenden Schleifmittels ("slurry"). Bei Verwendung entsprechender Drahtdurchmesser und Abstände der Drähte können großflächig auf einfache Weise gerundete Gräben verschiedener Breite, Tiefe und mit verschiedenen Abständen, d. h. mit unterschiedlich breiten Kontaktbereichen, erzeugt werden. Die Gräben können aber im Querschnitt auch nahezu rechteckig sein, mit sehr steilen Flanken und flachem Boden, mit abgerundeten Ecken, im Schnitt ellipsenförmig oder auch spitz zulaufend. Das Strukturieren mit parallelen Drähten, für das der Begriff wire grooving geprägt wird, kann erfolgen sowohl auf der Basis diamantbesetzter Drähte als auch nach der oben erwähnten Methode glatter Drähte, bei der sich das Schleifmittel in einer Flüssigkeit (slurry) befindet.

Einsatzmöglichkeiten des diesbezüglichen Verfahrens ergeben sich insbesondere auch in der optischen Industrie zur Strukturierung von Gläsern.

Zur Verringerung der Lichtreflexion können insbesondere Grabenboden und gegebenenfalls zumindest bereichsweise Wände noch besonders strukturiert sein, wobei die bekannte Texturierung mittels einer eine bestimmte Kristallebene bevorzugt abtragenden Ätze nur als Beispiel angeführt werden soll. Bei Vorliegen einer (100) orientierten Halbleiteroberfläche können dadurch vorteilhafterweise nicht texturierte, glatte Flanken (zur Reflexion des Lichtes in die Gräben hinein, insbesondere wenn die Flanken teilweise mit Metall bedeckt sind) und texturierte Grabenböden erhalten werden. Auch die horizontalen schmalen Kontaktbereiche können vorteilhafterweise texturiert sein, wodurch nach den weiter unten folgenden Ausführungen auf einfache Weise Punktkontakte entstehen.

Das erfindungsgemäß hervorzuhebende bevorzugt großflächige Abtragen der Passivierschicht und gegebenenfalls eines Teils des Halbleitermaterials im Bereich der sehr schmalen Erhebungen, die die späteren Kontaktbereiche bilden, kann neben anderen Methoden besonders vorteilhafterweise ebenfalls durch mechanische Methoden erfolgen. Hierbei sind über große Flächen gleichmäßiges Läppen, Fräsen, Schleifen und Bürsten mittels z. B. Fächerschleifen, Bürstwalzen, Schleifwalzen, Polierrollen etc. zu nennen, wobei wieder wegen der geringen Oberflächenschädigung des Halbleiters Drahtläppen ("wire lapping", "milling") mit Hilfe eines oder mehrerer Drähte hervorzuheben ist. Bei letzterem Vorschlag kann auf einfache Weise ein hoher Durchsatz erreicht werden, indem die Halbleiterscheiben kontinuierlich unter einem oder mehreren sich bewegenden Drähten in entsprechendem Abstand hindurchgefahren werden.

Neben den mechanischen Methoden zum lokalen Abtragen der Passivierschicht auf den erhöhten Bereichen können auch speziell entwickelte naßchemische Verfahren oder bevorzugt Trockenätzmethoden beispielsweise mit gerichtetem Ätzabtrag (Plasmaätzung, Ionenätzung, Laserätzung etc.) angewendet werden.

Beispielsweise kann ein parallel zur Oberfläche gerichteter Teilchen- oder Laserstrahl bevorzugt und ohne starke Schädigung die erhöhten Bereiche samt Passivierschicht in dem gewünschten Maße abätzen, ohne daß eine Justierung oder Maskierung erforderlich ist. Plasmaätzen durch eine mechanische Maske kommt ebenfalls infrage.

Die erfindungsgemäße Lehre zur Erzeugung erhöhter Kontaktbereiche, von denen selektiv auf einfache Weise die Passivierschicht entfernt und das Kontaktmetall aufgebracht werden kann, bezieht sich nicht nur auf relativ dicke selbsttragende Halbleiterscheiben, in die Gräben eingebracht werden. Vielmehr kann dieses Prinzip auch auf Dünnschichthalbleiter bzw. Dünnschichtsolarzellen angewendet werden, die auf einem Fremdsubstrat aufgebracht sind. Hierzu wird die Grabenstruktur bereits in das Fremdsubstrat eingearbeitet, das in der Regel aus Metall (meist mit einer darüberliegenden Diffusionsbarrierenschicht), aus leitfähiger oder isolierender Keramik, aus Graphit oder ähnlichen Materialien besteht. In der hierauf abgeschiedenen Halbleiterschicht, die aus polykristallinem sowie aus amorphem Silizium oder aus Verbindungshalbleitern bestehen kann, wird die Solarzelle einschließlich Passivierschicht aufgebaut und nach dem Erfindungsgedanken auf den erhöhten Bereichen die Passivierschicht entfernt und vorzugsweise durch ein oben beschriebenes selbstjustierendes Verfahren die Kontaktmetallisierung vorgenommen. Ein Ausführungsbeispiel der Dünnschichtsolarzellen wird weiter unten beschrieben.

Insbesondere ist erfindungsgemäß auch vorgesehen, daß eine gewünschte Struktur, insbesondere rinnenförmige Struktur der Solarzelle dadurch gewonnen wird, daß das Halbleitermaterial auf einem bereits strukturierten Substrat aufgebracht wird, das gleichzeitig den Rückkontakt bildet. Um zu vermeiden, daß in das Halbleitermaterial von dem Trägersubstrat ausgehend Fremdsubstanzen hineindiffundieren, wird das nach den zuvor beschriebenen Verfahren strukturierte Substrat mit einer als Diffusionsbarriere wirkenden Schicht wie z.B. Siliziumnitrid, Aluminiumoxid bedeckt. Anschließend wird die Schicht von den Spitzenbereichen der Erhebungen abgetragen - gleichfalls nach zuvor beschriebenen Verfahren - um kleinflächige Kontaktbereiche für die sodann aufzutragende Halbleiterschicht zur Verfügung zu stellen. Anschließend kann die Solarzelle entsprechend der erfindungsgemäßen Vorschläge aufgebaut werden.

Selbstverständlich kann bei den erfindungsgemäß sehr gut passivierten Solarzellen auf die Anwendung der selbstjustierenden Metallisierung verzichtet werden und statt dessen das Metall nach der herkömmlichen Art beispielsweise durch Vakuum-Aufdampfen durch eine mechanische Maske, durch Siebdruck oder andere Verfahren aufgebracht werden. Dazu wird die Passivierschicht auf den erhöhten Bereichen entweder gezielt nur im Bereich der später erfolgenden Metallisierung oder ganzflächig entfernt. Im letzteren Fall muß allerdings nach den meist in Streifenform hergestellten Metallbahnen noch eine Passivierung der vorher von der Passivierschicht befreiten, aber nicht mit dem Metall bedeckten erhöhten Bereiche der aktiven Solarzellenoberfläche bei entsprechend mit dem Metallkontakt verträglichen niederen Temperaturen erfolgen. Der Vorteil der letzteren Konfiguration gegenüber den herkömmlichen Zellen besteht darin, daß der größte Teil der Halbleiteroberfläche mit einer sehr guten Passivierung versehen ist und somit auch aufgrund der sehr kleinen Kontaktfläche hohe Wirkungsgrade zu erreichen sind.

Die erfindungsgemäße Lehre zur Erzeugung erhöhter Halbleiterbereiche und der selektiven Entfernung der Passivierschicht auf diesen Kontaktbereichen kann auch vorteilhafterweise zur einfachen Herstellung von neuartigen, äußerst gut passivierten Punktkontaktsolarzellen erweitert werden. Erfindungsgemäß ist es möglich, bei einfacher Technologie optimale Passivierschichten wie thermisches Siliziumdioxid oder Plasmasiliziumnitrid, die bei Temperaturen von 800°C - 1000°C bzw. 400°C - 500°C hergestellt oder nachbehandelt werden, zu verwenden, da deren Präparation vor der Kontaktherstellung erfolgen kann.

Erfindungsgemäß ist vorgesehen, an einer einkristallinen texturierten Siliziumoberfläche, die mit Pyramiden einstellbarer Größe besetzt ist, zunächst die Passivierschicht ganzflächig zu erzeugen und durch definiertes Abtragen der Pyramidenspitzen (vorzugsweise durch Schleifen oder Läppen) das Silizium als kleine quadratische Flächen (Pyramidenstumpf) freizulegen und dann schließlich ganzflächig oder in Streifen das Metall aufzubringen. Die Größe der Kontaktflächen kann infolge der sich nach unten verbreiternden Pyramiden durch die Tiefe des Abtrags der Pyramidenspitzen beliebig erhöht werden, bis hin zur 100%igen Metallbedeckung bei völliger Beseitigung der Pyramiden.

Die Flächendichte der Pyramiden und damit der Punktkontakte kann durch die Höhe der Pyramiden gezielt variiert werden. Mit zunehmender Höhe nimmt nämlich die Zahl der Pyramiden pro Flächeneinheit ab. Die Pyramiden oder anders geformte erhabene Bereiche können durch anisotropes Ätzen erzeugt werden, wie es beispielsweise zur Texturierung von Solarzellen zwecks Verminderung der Lichtreflexion angewandt wird. Für Silizium kommen alkalische Lösungen bei erhöhter Temperatur infrage, die für verschiedene Kristallorientierungen unterschiedliche Ätzraten aufweisen. Durch diesen Texturätzprozeß kann ohne Maskierung die Einstellung von Höhe und Dichte der Pyramiden erfolgen.

Somit sind auf einfache Weise Kontaktdichte und -fläche nach Belieben regelbar.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung eines den Zeichnungen zu entnehmenden bevorzugten Ausführungsbeispiels.

Es zeigen:
- Fig. 1a: einen Ausschnitt einer MIS Inversionsschichtsolarzelle,
- Fig. 1b: ein Detail der MIS Inversionsschichtsolarzelle nach Fig. 1a,
- Fig. 2a: einen Ausschnitt einer Solarzelle mit pn-Übergang und MIS-Kontakten,
- Fig. 2b: ein Detail der Solarzelle nach Fig. 2a
- Fig. 3a: einen Ausschnitt einer weiteren Solarzelle mit pn-Übergang,
- Fig. 3b: ein Detail der Solarzelle nach Fig. 3a,
- Fig. 4: einen Ausschnitt einer Dünnschichtsolarzelle,
- Fig. 5: einen Ausschnitt einer weiteren Ausführungsform einer Solarzelle,
- Fig. 6a: einen Ausschnitt einer zur Solarzelle nach Fig. 5 modifizierten Ausführungsform,
- Fig. 6b: ein Detail der Solarzelle nach Fig. 6a, zusätzlich mit einer Texturierung im Kontaktbereich,
- Fig. 7: eine Rückseite einer Solarzelle zur Sammlung von Majoritätsträgern,
- Fig. 8: einen Ausschnitt einer Punktkontakt-MIS-Inversionsschicht-Solarzelle mit texturierter Oberfläche,
- Fig. 9a: einen Ausschnitt einer weiteren texturierten Punktkontakt-Solarzelle,
- Fig. 9b: ein Detail der Solarzelle nach Fig. 9a,
- Fig. 10a: einen Ausschnitt aus einer weiteren Ausführungsform einer Solarzelle,
- Fig. 10b: ein Detail der Solarzelle nach Fig. 10a,
- Fig. 11: eine strukturierte Rückseite einer Punktkontakt-Solarzelle,
- Fig. 12: einen Ausschnitt eines weiteren Ausführungsbeispiels einer Rückseite einer Solarzelle,
- Fig. 13: ein Detail der Solarzelle nach Fig. 12,
- Fig. 14: einen Ausschnitt eines weiteren Ausführungsbeispiels einer Rückseite einer Solarzelle,
- Fig. 15: ein Detail der Solarzelle nach Fig. 14,
- Fig. 16: einen Ausschnitt einer Rückseite einer Solarzelle mit ersten und zweiten elektrisch leitenden Kontakten und
- Fig. 17: einen Ausschnitt einer Solarzelle mit strukturiertem Trägersubstrat.

Die erfindungsgemäßen Lehren sind grundsätzlich bei jeder Solarzelle realisierbar. In den Ausführungsbeispielen werden jedoch nur MIS Inversionsschicht-Solarzellen und Zellen mit dotiertem pn-Übergang beschrieben. Dabei werden - soweit wie möglich - für gleiche Elemente gleiche Bezugszeichen verwendet.

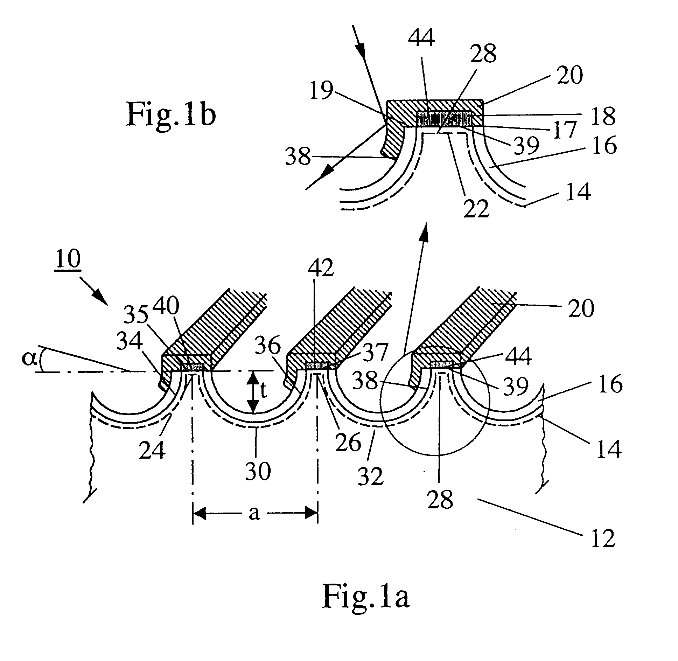

In Fig. 1a ist ein Ausschnitt der strahlungsseitigen Frontfläche einer MIS-Inversions-schichtsolarzelle (10) dargestellt. Die Zelle (10) besteht aus einem Halbleitergrundkörper (12), einer durch Ladung in einer Isolatorschicht induzierten Inversionsschicht (14) (bei p-Halbleiter aus Elektronen aufgebaut), einer durchsichtigen Isolator- bzw. Passivierschicht (16), einem dünnen Tunneloxid (18), das zusammen mit einem Metall (20) einen MIS-Kontakt zur Sammlung von Minoritätsträgern bildet. Mit dem Bezugszeichen (22) ist eine durch die Austrittsarbeitsdifferenz von Metall (20) und Halbleiter (12) an der Halbleiteroberfläche gebildete Inversionsschicht versehen. Die Rückseite der Solarzelle (10) kann beliebig gestaltet werden, beispielsweise aus einem ganzflächigen oder unterbrochenen Ohmschen Kontakt mit Passivierung des Zwischenbereiches bestehen, mit einem Rückseitenfeld (BSF) oder mit erhabenen Ohmschen Kontakten (siehe EP 88105201.3 A1), die auf ähnliche Weise durch lokales Entfernen der Passivierschicht und selektive Metallisierung hergestellt werden können wie obige Vorderseite. Insoweit wird auch auf die Offenbarung in der EP 88105201.3 A1 Bezug genommen.

Die Herstellung der Solarzelle (10) ist sehr einfach. Nach Ausbildung einer Grabenstruktur - parallel zueinander verlaufende erhöhte Bereiche oder Erhebungen (24), (26), (28) oder Stege und zwischen diesen verlaufende Vertiefungen (30), (32) wie Rinnen oder Gräben -an der Halbleiteroberfläche, vorzugsweise auf mechanische Weise, und Entfernung des Oberflächenschadens wird ganzflächig die Passivierschicht (16) (beispielsweise SiO₂, CVD SiO₂, Siliziumnitrid oder Doppelschicht SiO₂/Si₃N₄, bevorzugt plasmaunterstützt) aufgebracht. Auf den erhöhten Bereichen, die auch völlig spitz zulaufen können, wird die Isolierschicht (16) und je nach gewünschter Breite des Kontaktbereiches ein Teil des Halbleiters, bevorzugt auf mechanische Weise, entfernt. Nach Beseitigung einer möglicherweise erzeugten geschädigten Halbleitersubstratschicht wird die dünne Tunnelisolatorschicht (18) (∼ 1,5nm dick, beispielsweise Siliziumoxid, Oxynitrid oder Siliziumnitrid) erzeugt, gefolgt von der Schrägaufdampfung des Metalls (20) im Vakuum. Dadurch wird auf der Seitenflanke (34), (36), (38) der erhöhten Bereiche (24), (26), (28) wesentlich mehr Metall aufgebracht als auf den horizontal verlaufenden eigentlichen Kontaktbereichen (40), (42), (44) (in den Fig. ist dieser Sachverhalt nicht maßstabsgetreu wiedergegeben). Der Aufdampfwinkel bestimmt dabei die Breite des zu Kontaktfingern abgeschiedenen und ausgebildeten Metalls.

Das die elektrisch leitenden Kontakte auf den Erhebungen (24), (26) und (28) bildende Metall erstreckt sich folglich einerseits bereichsweise entlang der Flanken (34), (36) und (38) und andererseits entlang von plateauartigen Bereichen (35), (37) und (39). Innerhalb der plateauartigen Bereiche (35), (37) und (39) verlaufen die eigentlichen Kontaktbereiche (40), (42) und (44) zum Halbleitermaterial sowie die diese seitlich begrenzenden Stirnflächen (17) und (19) der Passiviersicht (16). Die Breite der plateauartigen Bereiche (35), (37) und (39) ist folglich stets größer als die doppelte Schichtdicke der Passivierungsschicht (16).

Der wesentliche dickere, auf dem Isolator (16) verlaufende Teil der Metallisierung - die auch einfach Kontakt genannt wird - stellt den eigentlichen Träger des Stromes dar, dessen Widerstand mit der Breite und Dicke beliebig klein gemacht werden kann, ohne die Abschattung merklich zu erhöhen.

Der horizontale Kontaktbereich (40), (42), (44) mit dem Halbleiter wird erfindungsgemäß, um einen niedrigen Sättigungssperrstrom (hohe Leerlaufspannung!) sowie geringe Lichtabschattung zu erhalten, sehr schmal ausgelegt, wobei die Breite u.a. einstellbar ist durch die Abtragungstiefe des Halbleitermaterials von den Erhebungen (24), (26), (28). Im Idealfall ergibt sich eine linienförmige Berührung, nämlich dann, wenn nur Passivierungsmaterial und kein Halbleitermaterial abgetragen wird.

In Fig. 1b ist gezeigt, wie die Metallisierung der Flanken (34), (36), (38) mit ihrer sehr geringen Abschattung noch das einfallende Licht auf die gegenüberliegende Halbleiterflanke reflektiert und damit zusätzlich durch den Schrägeinfall eine sehr gute Einkopplung des Lichtes und Sammlung der Ladungsträger bedingt.

In Fig. 1b wird auch deutlich, daß der Kontakt, also die Metallisierung, zumindest die durch das Abtragen des Passivierungsschichtmaterials gewonnenen Stirnflächen (17), (19) der Passivierschicht (16) abdeckt.

Als wesentliche Vorteile der Erfindung sind demnach hervorzuheben:
Selbstjustierende, also maskenfreie Aufbringung der Kontaktbereiche (20) bei minimaler Kontaktfläche und Lichtabschattung, aber trotzdem hoher Leitfähigkeit, sehr gute, unabhängig von den Metallkontakten (20) durchführbare Oberflächenpassivierung, die gleichzeitig für geringste Lichtreflexion zusammen mit einer möglichen Texturierung der Halbleiteroberfläche sorgt.

Somit wird eine MIS-Inversionsschichtsolarzelle zur Verfügung gestellt, mit der man auf einfache Weise höchste Wirkungsgrade erreichen kann.

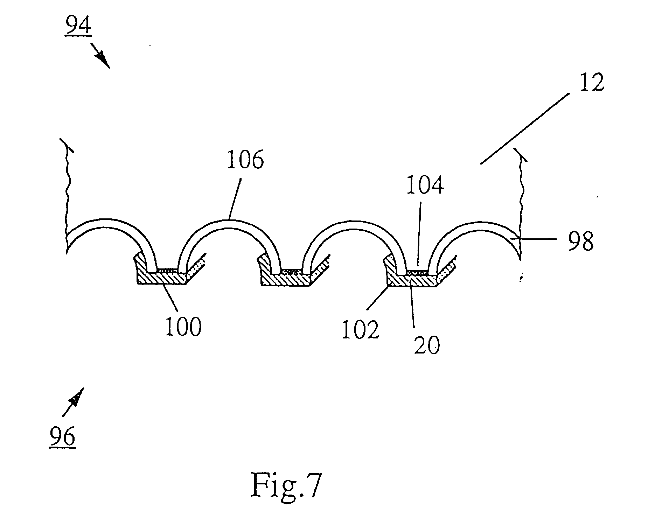

Wendet man eine der Fig. 1a, 1b entsprechende Struktur zur Sammlung von Majoritätsladungsträgern an (Fig. 7), so entfällt das Tunneloxid und das Metall wird im Falle des Siliziums bei Temperaturen von 350°C - 500°C zur Formierung des Ohmschen Kontaktes getempert.

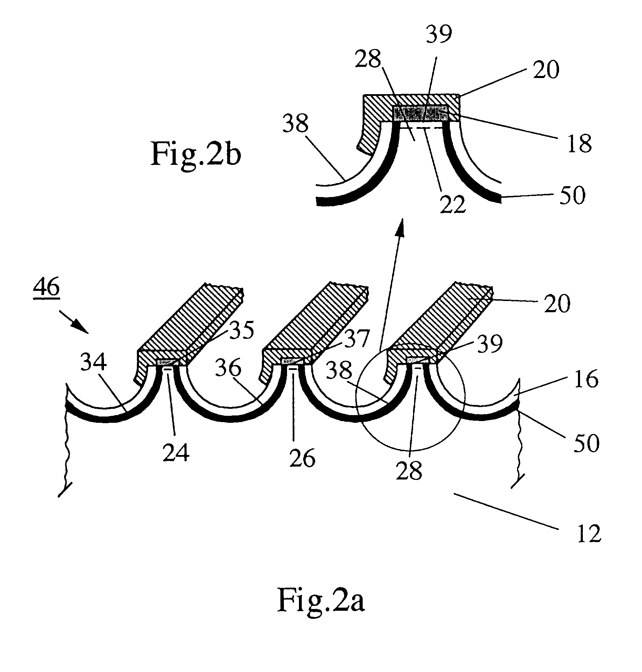

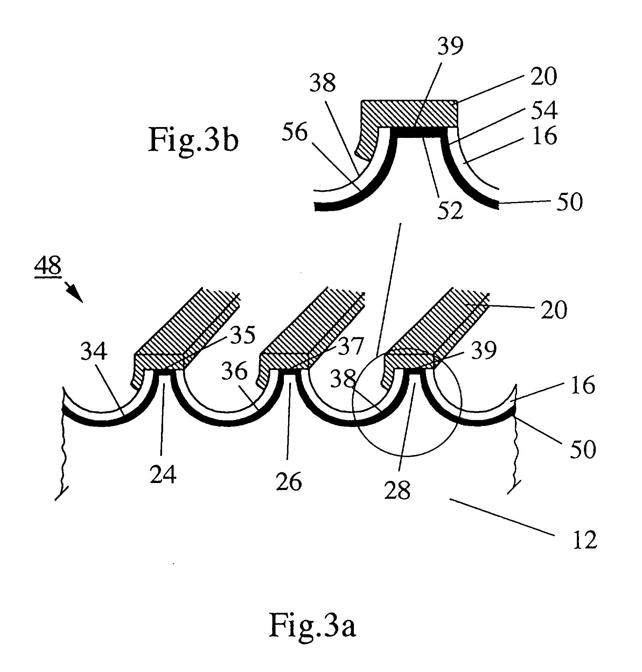

Die erfindungsgemäße Lehre läßt sich auch vorteilhafterweise auf konventionelle Solarzellen mit durch Diffusion bzw. Ionenimplantation hergestellten pn-Übergängen anwenden. In den Fig. 2a, 2b, 3a, 3b sind zwei Ausführungsbeispiele von Solarzellen (46) und (48) dargestellt, die beide eine hochdotierte Emitterschicht (50) im aktiven Bereich der Solarzelle (46) bzw. (48) unter der Passivierschicht (16) enthalten, die Kontakthereiche jedoch im Fall der Fig. 2a, 2b aus einem MIS-Kontakt, im Fall von Fig. 3a, 3b aus einem dotierten Kontakt bestehen.

In Fig. 2a, 2b sind der Halbleiterkörper (12), die durch Diffusion bzw. Ionenimplantation hergestellte hochdotierte Emitterschicht (50) (bei p-Halbleiter eine n⁺Schicht, bei n-Halbleiter eine p⁺Schicht), die Oberflächenpassivierschicht (16), die Tunnelschicht (18) (bei Silizium vorzugsweise etwa 1,5nm Siliziumoxid) für Minoritätsladungsträger und die Metallschicht (20) für den MIS-Kontakt dargestellt. Mit dem Bezugszeichen (22) ist die unter dem Metall (20) aufgrund der Austrittsarbeitsdifferenz von Metall und Halbleiter entstandene Inversionsschicht angedeutet. Es koppelt also im Falle des p-Halbleiters die n⁺Dotierschicht (50) des aktiven Halbleiteroberflächenbereiches direkt an die Elektronen-Inversionsschicht (22) des MIS-Kontaktes an. Der Elektronenübergang in das Metall erfolgt teils direkt aus der n⁺Schicht und teils über die Inversionsschicht. Auch hier sind wieder erfindungsgemäß auf einfache Weise die Vorteile des Schrägaufdampfens und der Oberflächenpassivierung gegeben, wie im Zusammenhang mit den Fig. 1a, 1b beschrieben worden ist.

In Fig. 3a, 3b, befinden sich an der gesamten Halbleiteroberfläche, im aktiven gut passivierten Gebiet wie auch unter den Metallfingern (20) ein hochdotierter Oberflächenhereich (50) (n⁺Schicht bei p-Halbleiter und p⁺Schicht bei n-Halbleiter) über den die Minoritätsladungsträger den Metallfingern oder Metallbahnen (20) zugeführt werden. Dabei sind erneut der Halbleitergrundkörper mit (12), die hochdotierte Oberflächenschicht im aktiven Bereich mit (50), die durchsichtige Passivierschicht (beispielsweise SiO₂, CVD SiO₂, Siliziumnitrid oder Doppelschichten) mit (16), der hochdotierte Bereich unter dem Metallfinger (20) mit (52) und die durch Schrägaufdampfen erhaltenen Metallkontaktbahnen mit (20) bezeichnet, die nur eine sehr kleine Kontaktfläche zum Halbleitersubstrat (12) besitzen und überwiegend auf der Passivierschicht (16) verlaufen.

Die hochdotierte Schicht (52) unter dem Metall (20) kann im günstigen Fall (tiefer pn-Übergang) durch das im schmalen erhöhten Bereich erfolgende Zusammenlaufen bzw. Überlappen von Dotiergebieten (54) und (56) gebildet werden oder durch eine zusätzlich nach dem lokalen Entfernen der Passivierschicht (16) (durch Abflachen der erhöhten Bereiche (24, (26), (28)) eingebrachte Dotierung.

In einem Teil des Kontaktbereiches, also unterhalb des Kontaktfingers (20), entsteht dann vorteilhafterweise eine durch die Doppeldiffusion bzw. Ionenimplantation entstandene sehr hochdotierte Schicht (52) (n⁺⁺ für p-Silizium), die den Sättigungssperrstrom der Solarzelle (48) weiter reduziert und damit insbesondere die Leerlaufspannung erhöht.

Wegen des einfach zu realisierenden geringen Kontaktabstandes und der hohen Leitfähigkeit der dotierten Oberflächenschicht (50) sowie der Kontaktbahnen eignet sich insbesondere die Solarzelle (48) auch für konzentriertes Licht.

Die Grabenstruktur im Halbleitermaterial (12), also die Gräben oder Rinnen (30), (32) und diese begrenzenden Erhebungen oder Stege (24), (26) und (28) werden erfindungsgemäß mechanisch, insbesondere durch relativ zum Halbleitermaterial (12) bewegte und parallel zueinander verlaufende Drähte oder Sägeblätter oder auch durch eine Gattersäge erzeugt. Dabei ergeben sich Abmessungen derart, daß der Abstand a zwischen benachbarten Erhebungen (24), (26) bzw. (28) im Bereich zwischen 30 µm und 2000 µm, vorzugsweise im Bereich zwischen 50 µm und 300 µm liegt.

Die Tiefe t der Gräben oder Rinnen (30) und (32), also der Abstand zwischen dem Boden des Grabens oder Rinne (30) bzw. (32) und der abgetragenen Spitze der Erhebungen (24), (26) und (28), also dem plateauartigen Bereich (35), (37) und (39) sollte vorzugsweise zwischen 25 µm, und 200 µm liegen. Insbesondere verhält sich der Abstand a der Erhebungen (24), (26) bzw. (28) zur Tiefe t der Rinnen oder Gräben (30) bzw. (32) wie 10 > a / t > 1,5.

Die bisherigen Ausführungsformen (Fig. 1a, 1b, 2a, 2b, 3a, 3b) beziehen sich darauf, daß die gezeigte Grabenstruktur erwähntermaßen durch mechanische Verfahren im Halbleitergrundkörper (12) selbst erzeugt wird. Vorteilhafterweise kann die erfindungsgemäße Lehre und die damit verbundenen Vorteile der zuvor erläuterten Solarzellenvorderseitenstrukturen aber auch für dünne Halbleiterfilme (58) realisiert werden.

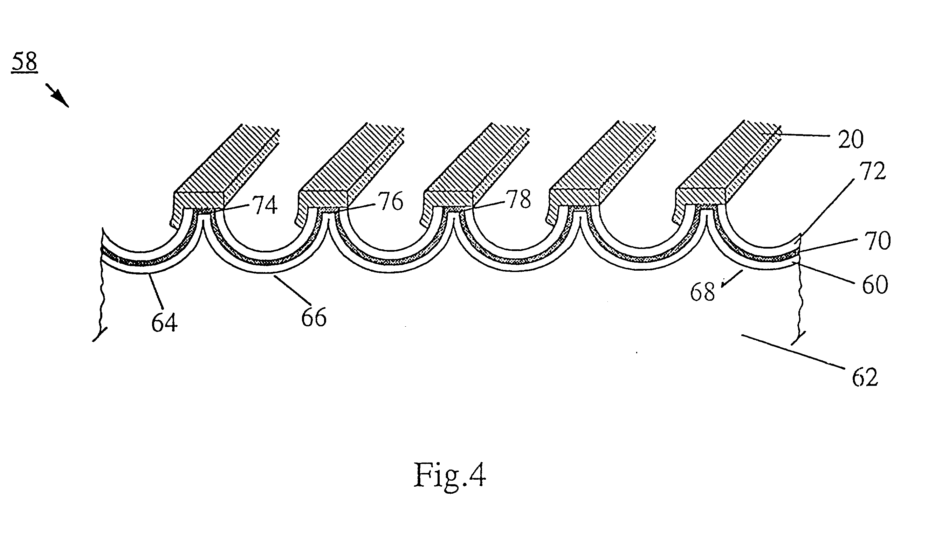

Wie in Fig. 4 angedeutet, wird ein entsprechend dotierter Halbleiterfilm (60) auf ein mit Gräben (64), (66), (68) versehenes Substrat (62) (beispielsweise aus Metall, Keramik, Graphit etc.) aufgebracht (die Struktur kann gleichfalls nach dem erfindungsgemäßen mechanischen Verfahren gewonnen werden). Die Oberseite des Halbleiterfilms (60) kann in Form einer Schicht (70) hochdotiert werden (z. B. bei p-Grunddotierung des Halbleiters wird eine n⁺Schicht erzeugt, Homo-pn-Übergang) oder die Schicht (70) besteht aus einem anderen Halbleiter zur Erzeugung einer Heterostruktur. Anschließend wird eine Passivierschicht (72) ganzflächig aufgebracht und diese lokal durch Abflachen von zwischen den Gräben (64), (66), (68) verlaufenden erhöhten Bereichen oder Erhebungen oder Stegen (74), (76), (78) entfernt. Sodann erfolgt vorteilhafterweise durch Schrägaufdampfen im Vakuum die Metallisierung in Form von Metallstreifen (20), die einen Vorderseitenkontakt der Solarzelle (58) zur Sammlung der Minoritätsladungsträger bilden. Der Rückseitenkontakt ist beispielsweise entweder durch das Substrat (62) oder durch eine leitfähige Schicht zwischen dem Substrat (62) und der Halbleiterschicht (60) gegeben.

Somit können auch für dünne Halbleiterfilme nach der erfindungsgemäßen Lehre sehr kleine Kontaktflächen bei geringer Abschattung und hoher Kontaktfingerleitfähigkeit in Verbindung mit einer sehr guten Oberflächenpassivierung erreicht werden.

Entsprechend den Ausführungsformen der Fig. 1a bis 2b können zusätzlich zu dem im skizzierten Beispiel für den Fall der Halbleiterfilme das Inversionsschichtprinzip mit Inversionsschicht im aktiven Bereich in Verbindung mit dem MIS-Kontakt bzw. hochdotierter Emitter im aktiven Bereich in Kombination mit MIS-Kontakten angewendet werden.

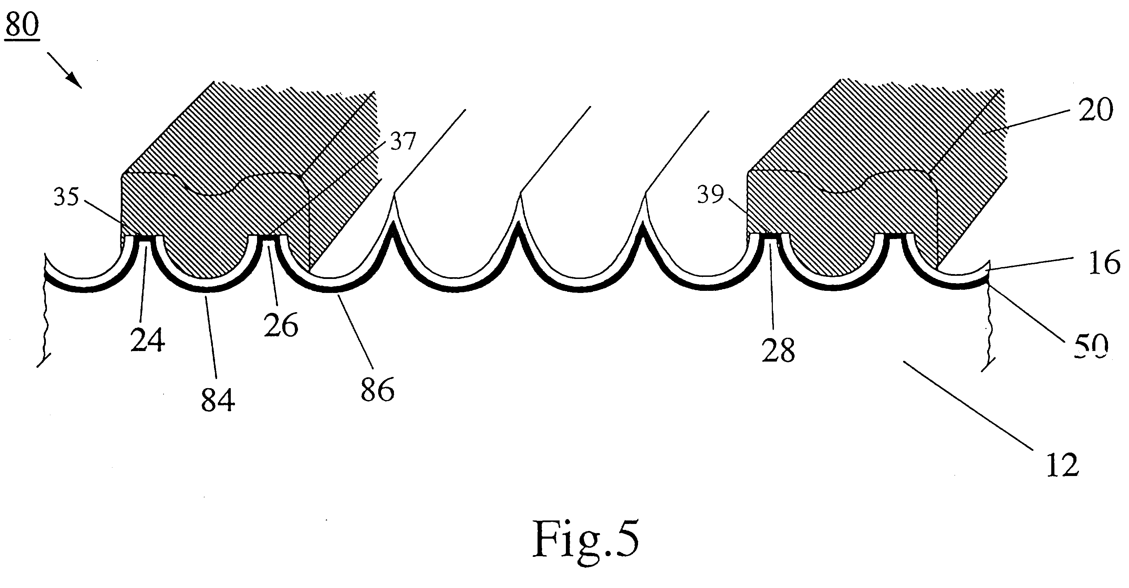

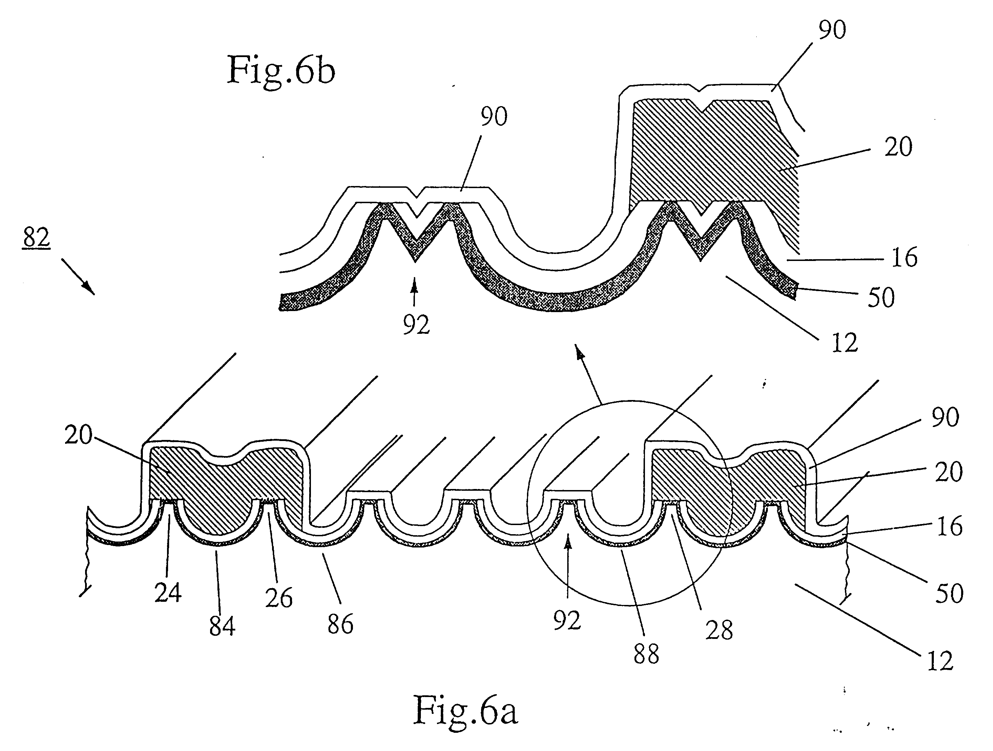

Eine weitere Ausführungsform der Erfindung, mit einfacher Technologie eine kleine Kontaktfläche bei sehr guter Oberflächenpassivierung und damit einen hohen Wirkungsgrad zu erhalten, ist anhand von Vorderseiten von Solarzellen (80), (82) in den Fig. 5, 6a und 6b aufgezeigt.

In beiden Beispielen ist die Halbleiteroberfläche wieder durch parallel laufende Vertiefungen oder Gräben (84), (86) und (88), die auf mechanischem Wege erzeugt werden, gekennzeichnet, wobei aber die Metallisierung zur Bildung von Kontaktfingern (20) nicht durch Schrägaufdampfen erfolgt.

In Fig. 5 werden nur im Bereich der Kontaktfinger (20) die Spitzen der erhöhten und mit Passivierschicht (16) versehenen Bereiche (24), (26), (28) abgetragen und beispielsweise durch eine mechanische Maske Metall durch Vakuumverdampfung oder Kathodenzerstäubung oder durch Siebdruck aufgebracht. Hierzu ist allerdings eine Grobjustierung erforderlich.

Die Ausführungsformen der Fig. 5, 6a, 6b sind nur für eine hochdotierte Emitterschicht (50) im aktiven Bereich und unter den Kontakten (20) wiedergegeben; es können aber auch der Inversionsschichtfall (analog Fig. 1a, 1b) sowie die Kombination von hochdotierter Schicht im aktiven Bereich und MIS-Kontakt (analog Fig. 2a, 2b) für diese Ausführungsformen angewendet werden.

In Fig. 5 sind (12) der Halbleitergrundkörper, (50) die hochdotierte Emitterschicht (z. B. n⁺Schicht für p-Halbleiter), (16) die durchsichtige Passivierschicht und (20) die Metallfinger dargestellt.

Um eine Justierung der Metallfinger (20) zu eliminieren, werden nach Fig. 6 ganzflächig die passivierten erhöhten Oberflächenbereiche (24), (26), (28) des Halbleiters (12) abgeflacht und damit schmale Bereiche des Halbleiters freigelegt. Die Metallbahnen (20) können nun beliebig, d. h. ohne Justierung, auf den Halbleiter aufgebracht werden. Es muß aber eine zusätzliche Passivierschicht (90) (z. B. plasmaunterstütztes CVD Siliziumnitrid) bei mit dem Metall verträglichen Temperaturen auf die freigelegten, nicht mit Metall bedeckten Halbleiterbereiche aufgebracht werden.

In Fig. 6 sind rein schematisch der Halbleitergrundkörper (12), die hochdotierte Emitterschicht (50) (z. B. n⁺ bei p-Halbleiter), die Passivierschicht (16) (z.B. thermisches SiO₂, CVD-SiO₂, Siliziumnitrid, Doppelschichten u.a.), die Metallisierung in Form der Finger (20) und die zweite Passivierschicht (90) dargestellt, für die thermisches SO₂, das in entsprechender Dicke nur bei hohen Temperaturen hergestellt werden kann, nicht mehr infrage kommt. Hierfür bieten sich beispielsweise plasmaunterstütztes CVD SiO₂ bzw. Siliziumnitrid oder Aluminiumoxid an. Die Doppelpassivierschicht, bestehend aus den Schichten (16) und (90), muß hinsichtlich Passivierung und Antireflexionseigenschaften optimiert werden durch Variation der jeweiligen Dicken und der Prozeßparameter. Der vergrößerte Ausschnitt in Fig. 6b soll die Möglichkeit zeigen, die erhöhten horizontalen Flächen sowohl im Bereich der Kontakte (20) als auch im aktiven Gebiet (92) der Solarzelle (82) zu texturieren und dadurch extrem kleine Kontaktflächen zu erzielen.

Der die Erfindung prägende Vorschlag, auf einfache Art sowohl eine optimale Oberflächenpassivierung des Halbleiters vor der Kontaktherstellung als auch kleinste Kontaktflächen mit selbstjustierender Kontakterzeugung zu ermöglichen, kann nicht nur zur Sammlung von Minoritätsladungsträgern (vorzugsweise auf der Vorderseite) angewendet werden, sondern auch zur Sammlung von Majoritätsladungsträgern vorzugsweise auf der Solarzellenrückseite.

So soll in Fig. 7 nur ein Beispiel einer Solarzelle (94) mit strukturierter Rückseite (96) mit Ohmschen Streifenkontakten, d. h. lokaler Metallisierung und lokalem Rückseitenfeld angegeben werden. Ein Halbleiterkörper (12), der im Beispiel p-dotiertes Silizium sein soll, ist mit einer Oberflächenpassivierschicht (98) (z.B. SiO₂, Siliziumnitrid, Siliziumoxynitrid, Aluminiumoxid, Doppelschichten etc.), versehen. Ferner sind streifenförmige Metallkontakte (100), (102) vorgesehen, die im Beispiel durch Schrägaufdampfen im Vakuum aufgedampft und bei entsprechender Temperatur zur Erzielung eines Ohmschen Kontaktes getempert wurden. Mit (104) ist eine durch Diffusion, Ionenimplantation oder Legieren erzeugte hochdotierte Schicht (im Beispiel p⁺Silizium) gekennzeichnet, wodurch ein lokaler pp⁺ Übergang zur Abstoßung der Minoritätsladungsträger ("back surface field") vorliegt. Die Passivierschicht (98) dient dabei nach dem Erfindungsgedanken gleichzeitig als Maskierung. Es kann aber auch auf die Anbringung des dotierten Gebietes (104) ganz verzichtet werden.

Die Solarzelle nach Fig. 7 eignet sich besonders für zweiseitige lichtempfindliche ("bifacial") Solarzellen, um auch das von hinten einfallende Licht besonders effizient auszunützen.

Die Metallschicht (100) kann lokal - wie im Zusammenhang mit den Fig. 1a - 4 erläutert -, aber auch nach anderen Verfahren selbstjustierend aufgebracht werden (z. B. stromlose Metallisierung, Tauchverfahren, Schleuderverfahren). Auch eine ganzflächige Metallisierung der Rückseite (96) ist möglich, wobei sich, da das Metall größtenteils auf der Passivierschicht (98) verläuft, bei geringer Kontaktfläche zusätzlich ein sehr guter optischer Rückseitenreflektor ("back surface mirror") ergibt.

Bei Verwendung eines n-dotierten Halbleitermaterials (12) in Fig. 7 stellt die Schicht (104) einen stark n-dotierten (n⁺) Bereich dar, so daß ein nn⁺Übergang vorliegt. Wiederum können die mit der Passivierschicht (98) bedeckten Vertiefungen oder Furchen (106) beliebige Formen haben (eckig, gerundete Kanten etc.) Auch hier steht die Erzeugung der Furchen (106) mittels der Drahtsäge- oder Gattersägetechnik im Vordergrund. Furchentiefe und Furchenabstand können in weiten Grenzen variieren. Die Kombination der in Fig. 7 skizzierten, mit Gräben (106) versehenen Solarzellenrückseite (96) mit den in Fig. 1a bis 6b aufgeführten, ähnlich strukturierten seitenkonfigurationen ist vorteilhaft, insbesondere wenn die Vertiefungen auf der Vorderseite senkrecht zu denen auf der Rückseite verlaufen.

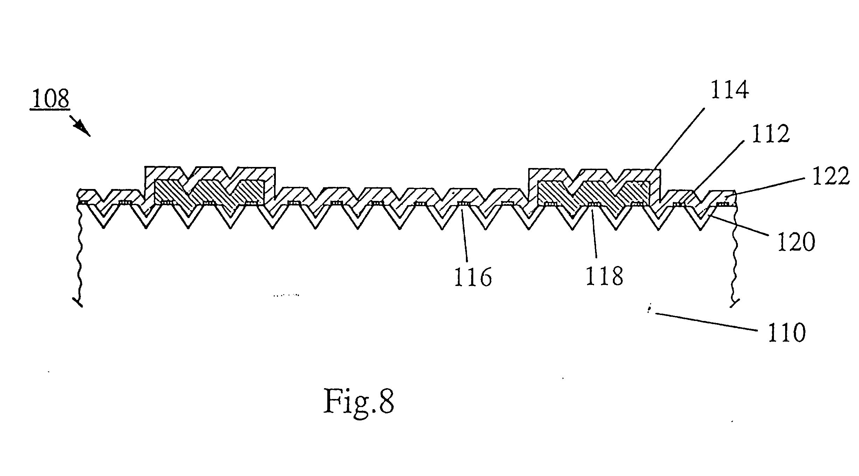

Anhand der Fig. 8 bis 11 soll die Anwendung der erfindungsgemäßen Lehre für texturierte, also vorzugsweise pyramiden- oder kegelförmige Vorsprünge aufweisende Solarzellen zur Erzielung von Punktkontaktsolarzellen erläutert werden.

Dabei soll die Erfindung zur Erzeugung von Punktkontakten am Beispiel eines Ohmschen, eines MIS-Kontaktes und eines dotierten Kontaktes beschrieben werden.

Auf aus einer Oberfläche eines Siliziumhalbleitersubstrats hervorspringende Pyramiden befindet sich zunächst eine Passivierschicht (z. B. therm. SiO₂, CVD Si₃N₄ etc.). Durch Abtragen der Pyramidenspitzen wird das Silizium freigelegt und mit Metall überzogen und im Fall des Ohmschen Kontaktes noch einer Temperung zwischen 400°C und 500°C unterzogen. Somit sind auf dem Pyramidenstumpf quadratische Punktkontakte entstanden. Die Seitenflächen oder Flanken sind passiviert.

Im Fall des MIS-Kontaktes läßt man nach dem Entfernen der Pyramidenspitze eine dünne Tunneloxidschicht aufwachsen. Sodann wird die Metallschicht abgeschieden. Die Methode kann auch vorteilhaft eingesetzt werden, um lokal diffundierte oder ionenimplantierte Gebiete beispielsweise für Punktkontakte zu erzeugen, da die Passivierschicht gleich als Maske dient und somit eine gezielte selbstjustierende Dotierung dieser Bereiche erlaubt. Wenn es sich beim Halbleiter um p-dotiertes Silizium handelt, kann durch n⁺-Dotierung (z. B. Phosphor) ein minoritätsträgersammelnder Punktkontakt (n⁺p), durch p⁺-Dotierung ein majoritätsträgersammelnder Kontakt (pp⁺) erzeugt werden. Entsprechendes gilt bei der Verwendung von n-dotiertem Silizium (p⁺n und n⁺n).

Die erfindungsgemäße Lehre der abgeflachten Pyramiden kann zunächst für die herkömmlichen, auf der Vorderseite die Minoritätsträger und auf der Rückseite die Majoritätsträger sammelnden Solarzellen vorteilhaft eingesetzt werden. In jedem Fall werden dadurch auf einfache Weise - wie bei den schon ausgeführten Zellentypen - eine optimale Passivierung der Halbleiteroberfläche, sehr kleine Kontaktflächen von Metall und Halbleiter und damit hohe Wirkungsgrade erreicht.

Dabei müssen an den zu kontaktierenden Stellen beispielsweise in Form einer Fingerstruktur mit geeigneten Methoden, vorzugsweise durch mechanisches Schleifen, Fräsen oder Läppen, die Pyramiden gezielt abgeflacht werden, um die Passivierschicht lokal zu entfernen. Schließlich sind die Metallbahnen aufzubringen. Letzteres kann beispielsweise durch Aufdampfen oder Sputtern durch eine justierbare mechanische Maske oder durch Siebdruck geschehen.

Für die Anwendung des Verfahrens auf die MIS-Inversionsschicht-Solarzelle, auf deren Vorderseite sich ein MIS-Kontaktgitter befindet und die aktive Fläche zwischen den Metallkontakten wie Kontaktfingern mit einer an der Grenzfläche zum Halbleiter Ladungen enthaltenden durchsichtigen Isolatorschicht bedeckt ist, müssen im Kontaktbereich die abgeflachten Pyramiden mit einer etwa 1nm - 2nm dicken sogenannten Tunneloxidschicht versehen werden. Die Pyramiden werden daher nur an den Stellen abgeflacht, auf denen die Metallfinger aufgebracht werden, also ähnlich zu dem in Fig. 5 gezeigten Fall der Grabenstruktur. Das Gebiet zwischen den Kontakten ist vollständig mit der Passivierschicht überzogen.

Im oben beschriebenen Fall ist es jedoch erforderlich, das Metall exakt auf die vorgesehenen, aus abgeflachten Pyramiden bestehenden Kontaktbereiche aufzubringen. Hierzu ist eine Justierung erforderlich. Um diese Justierung zu eliminieren, kann eine Struktur, die in Fig. 8 angedeutet ist, für die Solarzellenvorderseite zur Anwendung kommen.

Eine in Fig. 8 dargestellte Solarzelle (108) umfaßt u. a. einen Halbleitergrundkörper (110), eine dünne Tunneloxidschicht (112) und eine Metallisierung (114) für einen MIS Tunnelkontakt, eine vor der Abflachung von Pyramiden (116), (118) und vor Aufbringung der Metallisierung (114) bei höheren Temperaturen aufgebrachte Passivierschicht (120) (z. B. thermisches SiO₂, Si₃N₄ oder Doppelschicht) sowie eine nach der Metallisierung aufgebrachte Passivier-Isolatorschicht (122). Im Bereich der Pyramiden bzw. späteren Pyramidenstümpfe (116), (118) kann sich zwischen dem Halbleiter (110) und der Passivierschicht (122) noch eine zweite dünne Passivierschicht, vorzugsweise Siliziumoxid befinden.

Verfahrensmäßig wird wie folgt vorgegangen:
Nach der Passivierung der gesamten Vorderseite der Solarzelle (108) werden die Pyramiden (116), (118) abgeflacht und damit die Passivierschicht (120) lokal entfernt. Sodann wird auf den freigelegten Halbleiterstellen das Tunneloxid (112) der Dicke 1 nm bis 2 nm erzeugt und das Metallgitter (114) an beliebiger Stelle aufgebracht. Schließlich wird die so erhaltene Struktur mit der vorzugsweise aus der Gasphase bei Temperaturen bis 350°C abgeschiedenen Passivierschicht (122) überzogen, um insbesondere die zwischen der Metallisierung, also den Kontaktfingern (114) verbliebenen und zuvor freigelegten Halbleiterflächen (Pyramidenstümpfe (116)) zu passivieren und durch die eingebauten Isolatorladungen an diesen Stellen eine Inversionsschicht zu erzeugen. Plasmasiliziumnitrid in Verbindung mit einer Cäsiumkontamination ist hierfür gut geeignet. Der überwiegende Teil der Oberfläche, d. h. die Seitenflächen der Pyramidenstümpfe (116), sind mit der anfangs aufgebrachten sehr guten Passivierschicht (120) überzogen.

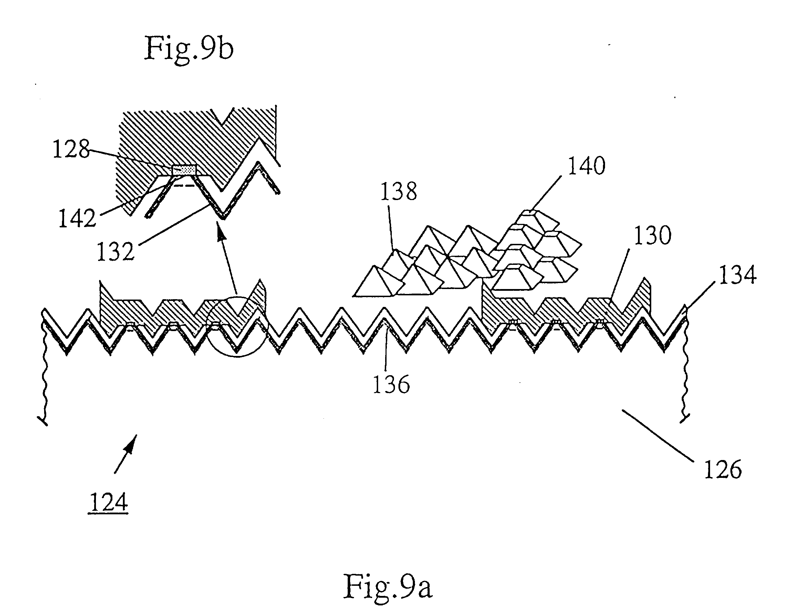

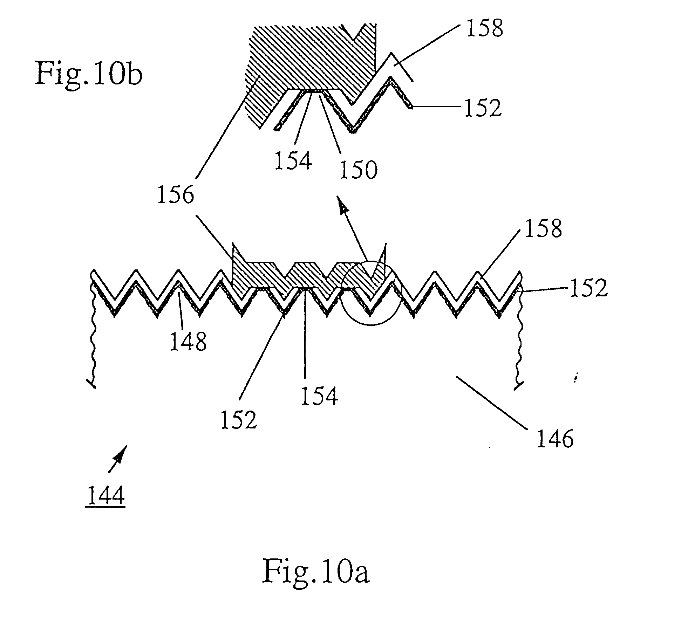

Eine Anwendung des erfindungsgemäßen Verfahrens auf eine herkömmliche, diffundierte oder ionenimplantierte Solarzelle erweist sich als sehr vorteilhaft. Dabei sollen drei Möglichkeiten hervorgehoben werden.
a) Kombination der dotierten aktiven Gebiete mit MIS-Kontakten (siehe Fig, 9a, 9b).
   Eine in Fig. 9 im Ausschnitt (ohne Rückkontakt) rein prinzipiell dargestellte Solarzelle (124) umfaßt einen Halbleitergrundkörper (126), ein Tunneloxid (128), eine Metallisierung für den MIS-Kontakt (130), eine vorwiegend durch Diffusion oder Ionenimplantation stark dotierte Oberflächenschicht (132) (Emitter, n⁺ bei p-Substrat bzw. p⁺ bei n-Substrat) und eine Passivierschicht (134) (z. B. thermisches SiO₂, CVD SiO₂, CVD Si₃N₄ Doppelschicht). Hierbei wird ganzflächig unter der texturierten, Pyramiden oder andere Geometrien aufweisende Erhebungen (136), (138) und passivierten Halbleiteroberfläche ein pn-Übergang beispielsweise durch Diffusion oder Ionenimplantation erzeugt (z. B. n⁺ Gebiet auf p-Silizium). Im Kontaktbereich wird die Passivierschicht (134) durch Abflachen der Pyramiden (136), (138) lokal entfernt und diese so gewonnenen Punktkontaktstellen (140), (142) mit der etwa 1 nm bis 2 nm dicken Tunneloxidschicht (128) versehen. Daran schließt sich das lokale Aufbringen der Metallschicht (130) an, wobei bei p-Silizium vorzugsweise die Aufdampfung von Aluminium infrage kommt. Dabei koppelt die n⁺Schicht direkt an die Inversionsschicht unter dem Metall (130) an. Zusätzlich kann über die gesamte Oberfläche inklusive Metallbahnen (130) eine Passivierschicht - wie in Fig. 8 - abgeschieden werden. Auch hier ist es zur Vermeidung der Justierung der Metallbahnen möglich, die Pyramiden auf der gesamten Vorderseite abzuflachen und nach der Metallisierung wieder ganzflächig eine Passivierschicht bei mit der Metallisierung verträglichen Temperaturen aufzubringen.
b) Doppeldiffusion im Bereich der Kontakte (siehe Fig. 10a, 10b).
   Durch das Abtragen der Pyramiden (136), (138) wird bei der diffundierten bzw. implantierten Solarzelle (124) gemäß Fig. 9a, 9b auch weitgehend das dotierte Gebiet und damit lokal im Kontaktbereich der pn-Übergang beseitigt. Bei einer normalen Kontaktierung (nicht wie in Fig. 9a, 9b) mit einem Metall niedriger Austrittsarbeit, um im p-Halbleiter Verarmung bzw. Inversion zu erzeugen und Einlegieren bei höheren Temperaturen würde somit ein Kurzschluß zum Substrat (126) entstehen.
   Durch die Ausführungsform gemäß Fig. 10a und 10b soll dies vermieden werden.
   Eine schematisch und im Ausschnitt dargestellte Solarzelle (144) weist einen strukturierten Halbleitergrundkörper (146) mit punktförmigen Erhebungen wie Pyramiden (148), (150) auf. Auf dem Halbleitergrundkörper (146) befindet sich eine anfänglich erzeugte dotierte Oberflächenschicht (152) (Emitter n⁺ bei p-Substrat bzw. p⁺ bei n-Substrat), eine nach dem Abflachen der Pyramiden (148), (150) nur im Kontaktbereich erzeugte hochdotierte Schicht (154), ein Kontaktmetall (156) und eine Passivierschicht (158).
   Es wird vorzugsweise durch Diffusion oder Ionenimplantation an der Kontaktstelle das hochdotierte Gebiet (154) erzeugt, wobei die Passivierschicht (158) als Maske dient. Anschließend wird, wie in der konventionellen Siliziumsolarzellentechnologie üblich, das Metall (156) mit gewünschten Eigenschaften aufgebracht und mit dem dotierten Gebiet (154) ein Ohmscher Kontakt mit niedrigem Übergangswiderstand erzeugt. Infolge der seitlich an den abgeflachten Pyramiden (150) vorhandenen Dotiergebiete (152) werden durch die Doppeldiffusion die partiell sehr stark dotierten Gebiete (154) (n⁺⁺) erzeugt, wodurch der Sättigungssperrstrom dieser Kontakte sehr niedrig und damit die erreichbaren Leerlaufspannungen und Füllfaktoren sehr groß werden. Zu einem niedrigen Sättigungssperrstrom trägt auch wesentlich die erfindungsgemäß klein ausgebildete Kontaktfläche bei.
   Analog zum Beispiel der MIS-Inversionsschichtsolarzelle nach Fig. 8 kann auch die diffundierte bzw. ionenimplantierte Solarzelle (144) ohne die Notwendigkeit einer Justierung des Metallgitters (156) hergestellt werden und zwar durch ganzflächiges Abtragen der Pyramidenspitzen mit anschließender ganzflächiger zweiter Diffusion oder Ionenimplantation, wobei dann die hochdotierten Gebiete (154) auf der gesamten Solarzellenoberfläche vorhanden sind. Analog zur Schicht (122) in Fig. 8 ist es auch hier vorteilhaft, eine zweite Passivierschicht über die gesamte Solarzellenoberfläche abzuscheiden, ohne jedoch die Kontakte (156) zu beeinträchtigen.
c) Bei nur geringer Abtragtiefe der Pyramiden und möglicherweise tieferen pn-Übergängen gelingt es jedoch wegen der Überlappung der dotierten Gebiete (siehe z. B. Fig. 6b sowie Fig. 9a, 9b, 10a, 10b) im oberen Bereich der Pyramiden, die hohe Dotierung im abgeflachten Kontaktgebiet zu erhalten, so daß sich eine Doppeldiffusion erübrigt und damit der Prozeß vereinfacht wird. Durch die Überlappung ist vorteilhafterweise eine Dotierungserhöhung gegeben.

Eine weitere sehr vorteilhafte Anwendung der erfindungsgemäßen Lehre zur Erzeugung erhöhter Bereiche und der lokalen Entfernung der Passivierschicht - vorzugsweise durch mechanische Methoden - ergibt sich aus einer Kombination der in den Fig. 1 bis 6 gezeigten Grabenstrukturen mit den in den Fig. 8 bis 10 aufgeführten Punktkontaktanordnungen in Form abgeflachter Pyramiden. Dadurch können auf einfache Weise extrem kleine Kontaktbereiche und daher zusammen mit der sehr guten Oberflächenpassivierung äußerst niedrige Sättigungssperrströme erzielt werden.

Wie anhand der Fig. 6b verdeutlicht werden sollte, ergeben sich durch die Texturierung der zwischen den Gräben vorhandenen erhöhten Bereiche wesentliche Vorteile. Zum einen sind im aktiven Gebiet der Solarzelle diejenigen Bereiche, die nicht von der optimal wirkenden Passivierschicht (16) abgedeckt sind, sehr klein, da diese Bereiche punktförmig sind. Hierdurch wird eine Rekombination von Ladungsträgern verringert. Zum anderen hat sich in dem Gebiet, das von den elektrisch leitenden Kontakten zum Ableiten der Ladungsträger bedeckt ist, die eigentliche Berührungsfläche zwischen dem Metall und dem Halbleiter durch die Punktkontakte erheblich reduziert. Der überwiegende Teil des Halbleiters bzw. der hochdotierten Schicht ist erwähntermaßen von der optimierten Passivierschicht (16) bedeckt. Diese Vorteile der Texturierung können für alle der in den Fig. 1 bis 7 gezeigten Ausführungsformen realisiert werden, wobei der Fall der Inversionsschichtsolarzelle nach Fig. 1a und 1b besonders hervorzuheben ist.

Erhöhte Punktkontakte können erfindungsgemäß auch auf andere Weise erzeugt werden. Ausgehend von den in Fig. 1 bis 7 gezeigten Grabenstrukturen, die beispielsweise durch Drahtsägen erzeugt wurden, kann durch ähnliches Sägen mit parallelen und definiert zueinander beabstandeten Drähten unter einem möglichst rechten Winkel zu den Ausgangsgräben eine regelmäßige Anordnung von sich nach unten erweiternden Säulen erzeugt werden. Der Querschnitt dieser Säulen und damit die Form der Punktkontakte kann rechteckig, quadratisch oder rautenförmig sein, je nach Sägewinkel. Eine beliebige Variation der Punktkontaktfläche ist durch die Wahl der Drahtabstände möglich.

Die Zellenrückseite für obige Anordnungen zur Sammlung der Majoritätsladungsträger kann in vielen Varianten ausgeführt sein. Sie kann beispielsweise untexturiert oder texturiert sein, ganzflächig oder in Streifen mit Metall bedeckt sein, wobei im letzteren Fall der Zwischenbereich mit einer Passivierschicht überzogen wird. Abflachen der Pyramiden im Kontaktbereich gemäß des Erfindungsgedankens, ganzflächig oder in Streifen, zur Reduzierung des Ohmschen Kontaktanteils ist ebenfalls möglich.

Analog zu der in Fig. 7 dargestellten Struktur zur Sammlung der Majoritätsladungsträger vorzugsweise auf der Solarzellenrückseite können auch die erfindungsgemäß vorgesehenen abgeflachten Pyramiden als Punktkontakte vorteilhafterweise mit einem lokalen Rückseitenfeld ("back surface field") zur Majoritätsträgersammlung eingesetzt werden.

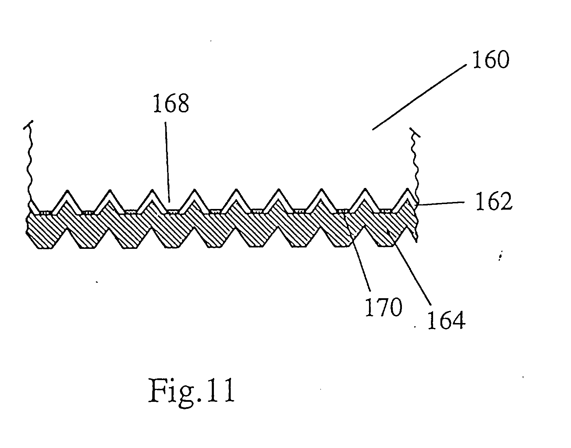

Ein Beispiel einer derartigen strukturierten Solarzellenrückseite ist der Fig. 11 zu entnehmen. Auf einem Halbleitergrundkörper (160) befindet sich eine Passivierschicht (162) (Einfach- oder Doppelschicht, therm. SiO₂, Siliziumnitrid etc.) eine Kontaktmetallschicht (164) und eine hochdotierte Zone (170) (bei Verwendung eines p-Halbleiters stellt dies eine p⁺Schicht dar) im Plateau der Strukturierung, die durch Pyramiden (168), Kegel, Säulen oder ähnliches gebildet ist, so daß im Pyramidenstumpf, also im abgeflachten Bereich der Pyramide (168), ein pp⁺ Übergang zur Abstoßung der Minoritätsträger vorliegt. Die Metallschicht (164) wird bei entsprechend höheren Temperaturen getempert, damit sie mit dem Halbleiter bzw. mit der hochdotierten Schicht (170) einen guten Ohmschen Punktkontakt bildet. Auf die Schicht (170) kann aber auch verzichtet werden. Das Metall (164) kann ganzflächig aufgebracht werden, wobei es größtenteils auf den mit der Passivierschicht (162) versehenen Pyramidenflanken verläuft und damit einen sehr guten Rückseitenreflektor ("back surface mirror") bildet.

Das Metall (164) kann aber auch, ähnlich wie in den Fig. 8 bis 10, in Streifenform aufgebracht werden, wobei die dazwischenliegenden Halbleiterbereiche vorzugsweise mit einer zweiten Passivierschicht überzogen werden können. Damit ist eine Ausnutzung des rückseitig einfallenden Lichtes möglich.

Die zweite Passivierschicht ist analog zu der Ausführungsform in Fig. 8 besonders dann erforderlich, wenn auf der gesamten Rückseite die Pyramiden (168) abgeflacht werden und damit der Halbleiter lokal von der Passivierschicht befreit ist. Ähnlich wie in Fig. 9 für die Minoritätsträger sammelnden Kontakte der Vorderseite gezeigt wurde, können die Pyramiden (168) auch nur im Bereich der Metallkontaktstreifen abgeflacht und hochdotiert werden, während im Gebiet zwischen den Streifen die völlig passivierten Pyramiden (168) erhalten bleiben.

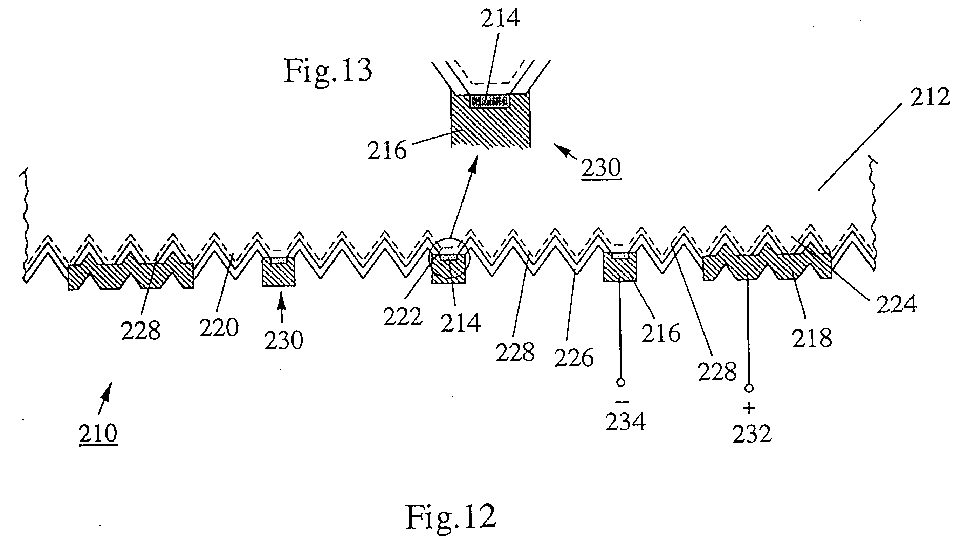

In den Fig. 12 bis 15 sollen anhand von Beispielen einige Varianten einer Kontaktanordnung (Minoritäts- und Majoritätsladungsträger sammelnde Kontakte) beschrieben werden, die auf einer Seite einer Solarzelle angeordnet sind. Vorzugsweise soll diese Konfiguration für die Rückseite von Solarzellen angewendet werden, geringe Kontaktflächen besitzen und gut passiviert sein. Die Vorderseite soll keine Kontakte aufweisen und nur mit einer sehr guten Passivierschicht (Antireflexschicht) oder mit einem zusätzlichen Minoritätsladungsträger sammelnden Kontaktsystem versehen sein.

Im Vordergrund steht eine Struktur mit ineinandergreifenden MIS- und Ohmschen Kontakten in Verbindung mit einer Inversionsschicht im Halbleiter.

Eine in Fig. 12 und 13 dargestellte Solarzelle (210) umfaßt einen Halbleiterkörper (212) (hier vorzugsweise p-leitendes Silizium), eine dünne Isolatorschicht (214), die von den Elektronen durchtunnelt werden muß. Die Isolatorschicht (214) bildet zusammen mit Metallstreifen (216) einen MIS-Kontakt (230) (Metall (216) - Isolator (214) - Silizium (212)) zur Sammlung der Minoritätsladungsträger.

Breitere Metallstreifen (218) bilden Ohmsche Kontakte zur Sammlung der Majoritatsladungsträger. Die Halbleiterkörper- oder -substratfläche ist strukturiert und weist im Ausführungsbeispiel pyramidenförmige Erhebungen (220), (222), (224) auf. Eine andere Geometrie wie Kegel oder Säulen ist gleichfalls möglich.

Die Erhebungen wie Pyramiden (220), (222), (224) sind mit einer durchsichtigen Isolatorschicht (226) überzogen, die an ihrer Grenzfläche zum Halbleiter positive Ladungen enthält (für den Fall der Verwendung von p-Silizium). Nach Abtragung der Pyramidenspitzen und damit der Passivierschicht und gegebenenfalls von Halbleitermaterial kann eine Kontaktierung mit dem Metall erfolgen.

Die Anordnung besteht demnach aus zueinander beabstandeten Ohmschen Kontakten (218) (zur Majoritätsträgersammlung, z. B. Aluminium auf Silizium), zwischen denen sich mehrere schmale MIS-Kontakte (230) (zur Minoritätsladungsträgersammmlung, z. B. Aluminium-1,4nm Siliziumoxid p-Silizium) mit geringeren Abständen befinden. Die jeweiligen Kontakte können vorzugsweise punkt- oder linienförmig ausgebildet sein, wobei mehrere Punkte zusammen einen einzigen Ohmschen Kontakt bilden können.

An der Halbleiteroberfläche wird aufgrund der positiven Isolatorladungen eine gut leitende Inversionsschicht (228) induziert. Unter dem MIS-Kontakt (230) im Silizium (212) befindet sich ebenfalls eine Inversionsschicht, hervorgerufen durch die Austrittsarbeitsdifferenz von Metall und Halbleiter.

Die Funktionsweise der Sammlung von Minoritätsladungsträgern durch diese Anordnung ist wie folgt:
Die durch das vorne oder hinten einfallende Licht erzeugten Minoritätsladungsträger (hier Elektronen) diffundieren aus dem Halbleiterinneren zur Inversionsschicht (228) und gelangen entlang dieser in horizontaler Richtung zu den MIS-Tunnelkontakten (230), durch die sie den Halbleiter verlassen und in einen äußeren Stromkreis gelangen (Minuspol (234)). Die Majoritätsladungsträger (hier Löcher) werden durch das an der Oberfläche im Gebiet zwischen den Ohmschen Kontakten (218) herrschende elektrische Feld von den MIS-Kontakten (230) abgestoßen, von den Ohmschen Kontakten (218) gesammelt und in einen äußeren Stromkreis geleitet (Pluspol (232)). Somit findet eine getrennte Sammlung von Minoritäts- und Majoritätsladungsträgern statt, wie es für die Funktion einer Solarzelle erforderlich ist. Im vorliegenden Fall erfolgt die Sammlung beider Ladungsträgerarten allein auf einer Seite, vorzugsweise auf der Rückseite der Solarzelle (210).

Die beiden Kontaktsysteme können beispielsweise in Form von ineinandergreifenden Gittern, konzentrischen Ringsystemen oder punktförmigen Kontakten realisiert werden.

Von all den bekannten Anordnungen unterscheidet sich die neue Konfiguration neben dem Vorhandensein abgeflachter passivierter Pyramiden (220), (222), (224) unter anderem dadurch, daß die Minoritätsladungsträger entlang der dünnen Inversionsschicht (228) in horizontaler Richtung zu den MIS-Kontakten (230) fließen müssen. Daher ist diese Anordnung besonders für großflächige terrestrische Anwendungen und weniger für bei starker Lichtkonzentration auftretende hohe Ströme geeignet.

Erfindungsgemäß soll die Fläche der MIS-Kontakte (230) aus drei Gründen möglichst klein sein:
a) Erreichen eines niedrigen Sättigungssperrstroms und damit einer hohen Leerlaufspannung der Solarzelle (210) (Bedeckungsgrad möglichst kleiner als 20 %);
b) Ausnützen der von hinten auf die Zelle (210) auffallenden Strahlung zur Ladungsträgererzeugung;
c) Ermöglichung, daß die langwellige Strahlung durch die Rückseite der Solarzelle (210) austreten kann, wodurch die Erwärmung der Solarzelle (210) vermindert und damit eine höhere Betriebsspannung erreicht wird.

Die durchsichtige Isolatorschicht (226), vorzugsweise thermisches Siliziumoxid, Plasmasiliziumnitrid o.a., kann bei beliebigen Temperaturen hergestellt und/oder getempert werden, um eine optimale Passivierung zu erhalten.

Es ist vorteilhaft, daß hohe Dichten positiver Ladungen in der Isolatorschicht (226) vorhanden sind, was im Falle des Plasmasiliziumnitrids einfach durch den Einbau von vorzugsweise Alkaliionen erreicht wird.

Bei der in Fig. 12 gezeigten Solarzelle (210) können auch die Pyramidenspitzen der gesamten Rückseite abgetragen werden (also nicht nur im Kontaktbereich). Dies erfordert jedoch die Abscheidung einer zusätzlichen Passivierschicht über die gesamte Zellenrückseite, um die nicht mit Metall bedeckten Pyramidenflächen zu passivieren.

Nach der bisherigen Kenntnis müßte jedoch bei der in Fig. 12 gezeigten Solarzelle (210) im Gegensatz zur eingangs beschriebenen IBC-Solarzelle ein grundsätzliches Problem auftreten, was zu einer drastischen Erniedrigung des Solarzellenwirkungsgrades führen sollte: Die beiden Pole (232), (234), MIS-Kontakte (230) und Ohmsche Kontakte (218), zwischen denen sich die Photospannung aufbauen soll, sind intern über die gut leitfähige Inversionsschicht (228) miteinander verbunden, was einem niedrigen Parallelwiderstand (Shunt), also quasi einem Kurzschluß entspricht. Ein Großteil der Ladungsträger müßte demnach nicht über den äußeren Stromkreis, sondern über die sehr gut leitende Inversionsschicht (228) an der Halbleiteroberfläche von einem Pol zum anderen abfließen, woraus neben einer reduzierten Leerlaufspannung insbesondere ein stark reduzierter Füllfaktor der Solarzelle (210) resultiert (niedriger Parallelwiderstand). Als Abhilfe könnte man nun an die Anwendung verschiedener, mehr oder weniger komplizierter Verfahren denken wie lokale Unterbrechung der Inversionsschicht, Einbau einer Akkumulationsschicht, lokale Erhöhung des Widerstandes der Inversionsschicht.

Überraschenderweise sind solche Maßnahmen jedoch bei einer Solarzelle mit der erfindungsgemäßen Rückseitenstruktur mit ineinandergreifenden oder auf andere Weise nebeneinander angeordneten Ohmschen Kontakten (218) und MIS-Kontakten (230) überhaupt nicht erforderlich. Vielmehr ist nachstehende Anordnung allein ausreichend:
1. Der Abstand zwischen MIS-Kontakt (230) und Ohmschen Kontakt (218) ist möglichst klein (etwa die Hälfte des Abstandes der MIS-Kontakte (230) untereinander).
2. Die verbleibende Halbleiterfläche, vorzugsweise p-Silizium, zwischen MIS-Kontakt (230) und Ohmschen Kontakt (218) ist, wie auch die Gebiete zwischen den MIS-Kontakten (230), mit der durchsichtigen Isolatorschicht (226), vorzugsweise Plasmasiliziumnitrid, überzogen, die an der Grenzfläche zum Halbleitersubstrat (212) eine möglichst hohe positive Ladungsdichte (beispielsweise durch Einbau von Cäsium) enthält, um eine gut leitfähige Inversionsschicht (228) im Halbleitersubstrat (212) zu erzeugen.

Entgegen der bisherigen Auffassung werden mit dieser Anordnung möglichst viele Minoritätsladungsträger vom Ohmschen Kontakt (218) weg entlang der Inversionsschicht (228) zu den MIS-Kontakten (230) geleitet. Eine Ableitung von Elektronen aus dem Inversionskanal (228) zu den Ohmschen Kontakten (218) und damit eine Erniedrigung des Parallelwiderstandes erfolgt wider Erwarten auch ohne zusätzliche Maßnahmen nicht. Je näher der MIS-Kontakt (230) an dem Ohmschen Kontakt (218) zu liegen kommt, desto höher werden Kurzschlußstrom und Füllfaktor und damit der Wirkungsgrad der Solarzelle.

Sofern die Kontakte streifenförmig ausgebildet sind, sollten die Abstände der MIS-Kontaktfinger untereinander etwa 10 - 30 mal größer als die Breite der Kontakte selbst sein. Bei den Ohmschen Kontakten, die breiter als die MIS-Kontakte sind, sollte ein ähnliches Verhältnis bestehen. Die Abschattung durch die Ohmschen und MIS-Kontakte (218) bzw. (230) beträgt jeweils etwa 5% - 10%.

Um die geringen Abstände zwischen den Ohmschen Kontakten (218) und den MIS-Kontakten (230) zu erreichen, ist eine exakte Justierung der beiden Metallgitterstrukturen zueinander erforderlich. Dies kann auf herkömmliche Weise beispielsweise durch Photolithographie und Ätzen der Metallschichten oder durch Aufbringen des Metalls durch mechanische Masken, die mit Justiermarken versehen sind, erfolgen. Dabei ist auch die gezielte Aufbringung des Metalls durch Siebdruck möglich.

Die in Fig. 12 gezeigte Solarzellenrückseite (210) kann in Analogie zur IBC oder PC Solarzelle natürlich auch vorteilhafterweise für dotierte Punktkontakte ausgelegt werden, wobei sich die Passivierschicht auf den Pyramidenstümpfen als ideale selbstjustierende Dotiermaske eignet. Im Falle von p-Silizium liegen dann n⁺Punktkontakte (die Minoritätsträger sammeln) neben p⁺Punktkontakten (die Majoritätsträger sammeln) auf den Pyramidenstümpfen vor, wobei das Zwischengebiet mit einer Passivierschicht bedeckt ist.

Ein eigenerfinderischer Vorschlag sieht vor, daß unter Einbeziehung der abgeflachten Pyramiden durch einen einfachen selbstjustierenden Prozeß die zuvor erwähnten und für einen Massenfabrikationsprozeß weniger geeigneten Justiervorgänge vermieden werden können.

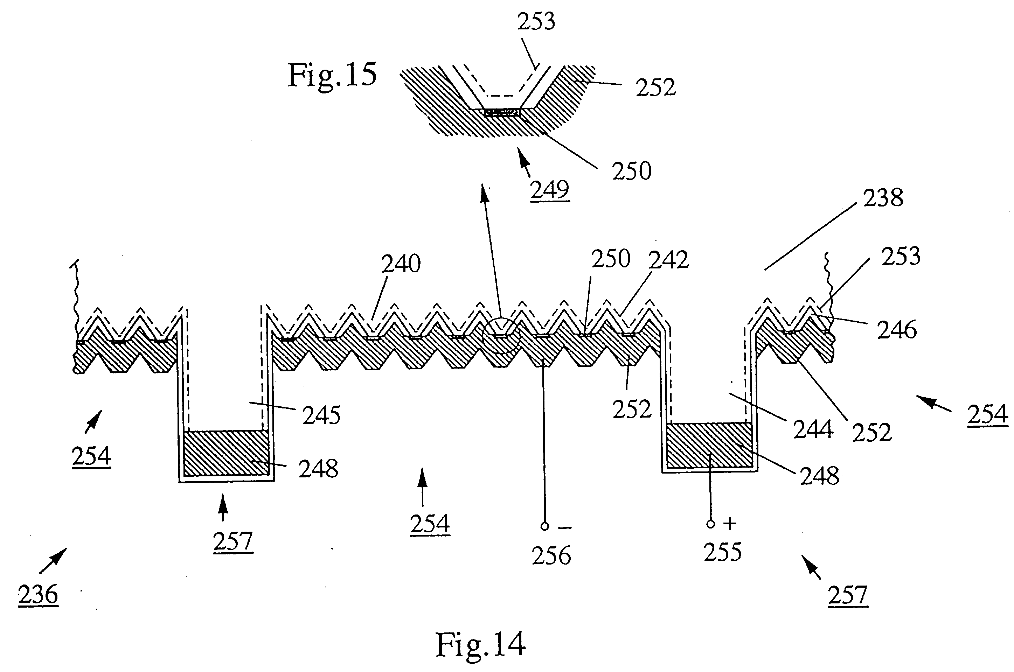

Wie in der Europäischen Patentanmeldung EP-A-286 917 beschrieben ist, kann eine Halbleiter- wie Siliziumrückseite durch verschiedene Methoden derart strukturiert abgetragen werden, daß in bestimmten Abständen (bis in den Millimeterbereich) erhabene Bereiche stehen bleiben, auf denen Ohmsche Kontakte zur Sammlung von Majoritätsladungsträgern angeordnet sind. Im Bereich zwischen diesen als Kontaktstege zu bezeichnenden Ohmschen Kontakten sind Minoritätsträger sammelnde Kontakte angeordnet, entweder in Form einer MIS-Fingerstruktur (analog zu Fig. 12) auf den abgeflachten und passivierten Pyramiden oder als ganzflächiger Metall-Isolator-Siliziumbereich wie in Fig. 14 dargestellt ist.

In den Fig. 14 und 15 sind Ausschnitte einer Rückseite einer Solarzelle (236) dargestellt, die ein Halbleiter- wie Siliziumsubstrat (238) mit pyramidenförmigen Erhebungen (240), (242) aufweist. Vor Ausbildung der Erhebung (240), (242) wurden aus dem Halbleitersubstrat stegförmige Vorsprünge (244), (245) gebildet. Auf die Vorsprünge (244), (245) wurde sodann Metall (248) zur Bildung der Ohmschen Kontakte (257) abgeschieden. Anschließend wird die gesamte Halbleitersubstratfläche mit einer Passivierschicht (246) abgedeckt. Schließlich werden die Spitzen der Pyramiden o.ä. Erhebungen (240), (242) also die Passivierschicht und gegebenenfalls bereichsweise das Halbleitermaterial abgetragen, um eine dünne Isolatorschicht (250) auf dem freigelegten Halbleitersubstrat anzuordnen. Der Bereich zwischen den Ohmschen Kontakten (257) wird sodann mit Metall (252) abgedeckt. Das Metall (252) bildet entsprechend der flächigen Erstreckung der Isolatorschicht (250) mit dem darunter befindlichen und freigelegten Halbleiter das Metall von MIS-Kontakten (254). An der Halbleiteroberfläche wird eine Inversionsschicht (253) induziert.

Mit anderen Worten ist bereichsweise Metall (252), Isolatorschicht (250) und Halbleitersubstrat ein MIS-Kontakt (254).

Der erhabene Ohmsche Kontakt (257) selbst kann auf seiner Oberfläche eben sein oder - ebenso wie das Zwischengebiet - aus abgeflachten Pyramiden oder anderen Erhebungen bestehen. Die Aufbringung des Metalls für die erhabenen Kontakte (257) kann, vor der Erzeugung der erhabenen Halbleiterbereiche, also der Erhebungen (244), (245), ganzflächig erfolgen oder nachträglich vorzugsweise selbstjustierend durch Schrägaufdampfen im Vakuum. Im letzteren Fall wird unter einem sehr flachen Winkel aufgedampft, wodurch jeweils die eine Flanke des erhabenen Halbleiterbereiches mit viel Metall, der Oberflächenbereich mit wesentlich weniger Metall bedeckt wird. Auch mit Hilfe einer mechanischen Maske kann das Metall auf die erhabenen Bereiche aufgebracht werden.

Die Metallisierung (248) der erhabenen Bereiche (244), (245) kann auch erst nach Aufbringen der Passivierschicht (246) und nach lokalem Entfernen derselben auf der Oberseite der Bereiche (244) und (245) erfolgen. In diesem Fall bedeckt das Metall zumindest bereichsweise die Passivierungsschicht (246).

Um auf einfache Weise einen definierten, minimalen Abstand von Ohmschem Kontakt (257) und MIS-Kontakt (254) ohne die Gefahr eines lokalen Kurzschlusses zu erhalten, wird erfindungsgemäß nach Fertigstellung der Ohmschen Kontakte (257) das Metall für die MIS-Kontakte (254) in einer Vakuumaufdampfanlage weitgehend senkrecht aufgedampft. Dabei erfolgt eine gleichmäßige Beschichtung sowohl im tieferliegenden MIS-Kontaktbereich als auch auf den erhabenen Ohmschen Kontakten (248), während auf den senkrechten oder leicht geneigten Flanken sich kein oder nur wenig Metall abscheidet. Eine Metallätzung stellt sicher, daß die Flanken der erhöhten Kontaktbereiche (244) frei von Metall sind und damit ohne besondere Justierung eine exakte Trennung von Ohmschen Kontakten (257) und MIS-Kontakten (254) erfolgt

Der zwischen den Ohmschen Kontakten (257) vorhandene und mit dem Bezugszeichen (254) versehene MIS-Kontakt ist im eigentlichen Sinne ein MIS-Kontaktbereich, der sich aus einzelnen MIS-Kontakten (249) zusammensetzt, die jedoch über die Metallisierung (252) leitend untereinander verbunden sind und den Minus-Pol (256) bilden.

Aus Gründen der Einfachheit wird der sich zwischen Ohmschen Kontakten (257) erstreckende MIS-Kontaktbereich als MIS-Kontakt (254) bezeichnet.

Der räumliche Abstand der Kontakte (257) und (254) ist durch die Höhe und Form der erhabenen Bereiche festgelegt. Durch naßchemisches Ätzen, Plasmaätzen, mechanisches Abtragen oder andere Methoden können Höhe und Form beliebig eingestellt werden. Die Bereiche können durch schräge Flanken begrenzt sein, wie es beispielsweise durch naßchemisches anisotropes Ätzen erreicht wird, oder durch senkrechte, abgerundete oder andersartig geformte Seitenwände. Abgesehen von der mechanischen Stützfunktion, durch die der Halbleiter unproblematisch sehr dünn gemacht werden kann (wichtig für rückseitig sammelnde Solarzellen!), unterscheidet sich die Aufgabe der erhabenen Bereiche in Fig. 14 erheblich von der Anordnung, wie sie in der EP-A-286 917 aufgeführt ist. Dort war die Forderung gestellt, daß Höhe der Bereiche plus Dicke des Halbleitersubstrats in der Größenordnung der Diffusionslänge der Minoritätsladungsträger liegen müssen, damit diese Ladungsträger den Ohmschen Kontakt nicht mehr erreichen können. Im vorliegenden Fall jedoch ist diese Bedingung von untergeordneter Bedeutung, da infolge der unmittelbar angrenzenden Inversionsschicht (253) und der MIS-Kontakte (254) die Minoritätsträger praktisch schon vor dem Eintreten in den erhabenen Kontaktbereich (257) seitlich abgesaugt und über den MIS-Kontakt (254) einer Nutzung zugeführt werden. Diejenigen Minoritätsträger, die doch in den erhabenen Bereich (244), (245) gelangen, werden dann durch die Inversionsschicht (253) entlang der Flanken zu den MIS-Kontakten (254) abgeführt. Durch diese beidseitig erfolgende seitliche Absaugung der Minoritätsträger ist bei einer entsprechenden Geometrie der erhöhten Bereiche (244), (245) (vorteilhaft: Breite kleiner als die zweifache Diffusionslänge) der Majoritätsträger sammelnde Kontakt (257) völlig vom Erreichen durch Minoritätsträger abgeschirmt.

Diese auf einfache Weise erzeugte Rückseitenanordnung übertrifft somit das herkömmliche Rückseitenfeld (BSF = Back Surface Field) in seiner Wirkung zur Abstoßung der Minoritätsträger. Zur Reduzierung des Ohmschen Kontaktwiderstandes kann zusätzlich auf dem erhabenen Bereich vor bzw. in Verbindung mit der Metallaufbringung ein Legier- oder Diffusionsprozeß angewandt werden (z.B. pp⁺), wodurch auch noch ein Getterprozeß zur Verbesserung der Lebensdauer der Minoritätsträger erfolgt.

Auch die in der EP-A-286 917 gestellte Forderung, die Abstände der Ohmschen Kontakte untereinander größer als die zweifache Diffusionslänge zu wählen, trifft bei der erfindungsgemäßen Anordnung nicht mehr zu. Die Ohmschen Kontaktbereiche (257) können beliebig dicht aneinandergereiht werden, da die Minoritätsträger infolge des Absaugens durch die Inversionsschicht (253) nebst Raumladungszone auch bei sehr kleinen Abständen überhaupt nicht mehr zu dem eigentlichen Ohmschen Metall-Halbleiterkontakt (257) gelangen können.

Die Funktion der einseitig kontaktierten Solarzelle (236) beruht erfindungsgemäß darauf, daß durch die die beiden Pole (MIS-Kontakt (254), Ohmscher Kontakt (257)) in Fig. 14 verbindende Inversionsschicht (253) kein Elektronenübergang, d. h. kein interner Kurzschluß (shunt)) erfolgt. Im Sinne eines geringen Serienwiderstandes und einer geringen Rekombination sollten die Ohmschen Kontaktbereiche nicht zu breit sein (Breite ≈ 100 µm) und ihr Abstand nicht zu groß gemacht werden. Beispielsweise dürfte bei einer Diffusionslänge von 150µm - 200µm, einer Kontaktbreite von 100µm und einer Kontakthöhe von 80µm der Ohmsche Kontakt (257) völlig von Minoritätsträgern abgeschirmt sein.

Was die Gestaltung der Solarzellenvorderseite für die in den Fig. 12 bis 15 gezeigten Rückseitenstrukturen betrifft, so gibt es mehrere Möglichkeiten, je nachdem welchen Solarzellentyp man erhalten möchte:
1) Solarzelle mit rückseitiger Sammlung der Ladungsträger und der Möglichkeit der beidseitigen Lichtausnützung:
   Bei dieser Anordnung kann für die Rückseite die Struktur nach Fig. 12 mit unterbrochenen MIS-Kontakten verwendet werden, wenn beidseitige Lichtausnützung erwünscht ist.
   Mit der in Fig. 14 gezeigten Struktur ist wegen des optischen Reflektors an der Rückseite eine effiziente einseitige Solarzelle gegeben. Die Vorderseite enthält keine Kontakte und damit auch keine Lichtabschattung, da sowohl Löcher als auch Elektronen an der Rückseite gesammelt werden.
   Von äußerster Wichtigkeit ist es, daß die Vorderseite eine sehr niedrige Oberflächenrekombinationsgeschwindigkeit besitzt, d. h. die in ihrer Nähe durch das Licht erzeugten Ladungsträger dürfen nicht an dieser Oberfläche rekombinieren. Hierzu kann analog zur schon erwähnten Front Surface Field (FSF) Solarzelle unter der Antireflexionsschicht ein pp⁺-Übergang an der Vorderseite erzeugt werden, der durch seine Potentialbarriere die Minoritätsladungsträger am Erreichen der Oberfläche hindert. Es kann aber auch wie im Falle der Tandem Junction Solarzelle ein majoritätsladungsträgerabstoßender oberflächlicher pn-Übergang erzeugt werden. Bei der Erzeugung eines pn-Überganges bzw. eines pp⁺-Überganges handelt es sich um aufwendige Hochtemperaturprozesse. Ferner muß zusätzlich eine Antireflexionsschicht aufgebracht werden. Um dem Niedertemperaturaspekt zu genügen und um einfache kostengünstige Herstellprozesse zu erreichen, ist vorgesehen, daß Oberflächenpassivierung und Antireflexionsschicht in einem Prozeßschritt erreicht werden. Dazu wird auf der Vorderseite der Solarzelle eine Wasserstoff enthaltende Isolatorschicht entsprechender Dicke auf dem natürlichen oder absichtlich thermisch erzeugten Oxid abgeschieden, wodurch sowohl die Oberflächenzustände abgesättigt werden als auch die Reflexion an der Halbleiteroberfläche vermindert wird. Isolatorladungen sind dabei von Vorteil, so daß die Siliziumoberfläche entweder angereichert ist oder sich in Inversion befindet. Sehr gut geeignet ist Siliziumnitrid, das vorzugsweise in der Glimmentladung bei Temperaturen zwischen 350°C und 600°C (Herstell- oder Nachbehandlungstemperatur) und beispielsweise durch Reaktion der wasserstoffhaltigen Komponenten Silan (SiH₄) und Ammoniak (NH₃) abgeschieden wird.
   Mit seinem in weiten Grenzen veränderbaren Brechungsindex (zwischen 1,8 und 2,6) kann für jede Anordnung minimale Reflexion erzielt werden, wobei gleichzeitig ein perfekter Schutz der Oberfläche gegen das Eindringen von Verunreinigungen gegeben ist.
   Eine derartige Schicht wurde schon in der DE 35 36 299 A1 zur Verminderung der Oberflächenrekombinationsgeschwindigkeit verwendet. Andere dünne Isolatorschichten, die sowohl zur Passivierung als auch zur Reflexionsminderung geeignet sind und vorteilhafterweise positive oder negative Ladungen enthalten, sowie thermisches Siliziumoxid kommen ebenfalls in Frage. Vorzugsweise sollte die Oberfläche texturiert sein.
   Bei der erfindungsgemäßen Solarzelle fällt das Licht ohne jegliche Abschattung durch die Oberfläche in den Halbleiter ein und erzeugt im Inneren, jedoch relativ nahe der Oberfläche, Elektron-Loch-Paare. Beide Ladungsträgerarten müssen nun zur Rückseite diffundieren, wobei die Minoritätsladungsträger von den MIS-Kontakten (254), die Majoritätsladungsträger von den Ohmschen Kontakten (257) gesammelt und über einen äußeren Stromkreis (+ Pol (255), -Pol (256)) zur Arbeitsleistung verwendet werden (Fig. 14).
   Die Dicke des Halbleitersubstrates (238) soll dabei kleiner als die Diffusionslänge der Minoritätsladungsträger sein, damit möglichst viele dieser Ladungsträger ohne Rekombination zur Rückseite gelangen können. Die Minoritätsladungsträger gelangen sowohl direkt als auch über die Inversionsschicht (253) zu den MIS-Kontakten (254). Es kann auch das von hinten auffallende Licht sehr gut ausgenützt werden, da die nahe der Rückseite durch das von hinten einfallende Licht erzeugten Ladungsträger optimal gesammelt werden.
2) Solarzelle mit beidseitiger Sammlung von Minoritätsladungsträgern:
   Bringt man zusätzlich zu den beiden Kontaktanordnungen auf der Rückseite (Fig. 12 bis 15) auch an der Vorderseite der gezeigten Solarzelle Kontaktstege an, die in der Lage sind, Minoritätsladungsträger zu sammeln, so ändert sich das Verhalten der Zelle drastisch. Es ergeben sich entscheidende Vorteile, sowohl bei nur vorderseitiger als auch bei beidseitiger Beleuchtung.
   Fällt Licht nur von vorne auf die Zelle, so resultiert infolge der Sammlung der Minoritätsladungsträger auf beiden Seiten bei gleicher Dicke und Qualität (Diffusionslänge) des Halbleitermaterials ein höherer Sammlungswirkungsgrad als bei der normalen BSF (Back Surface Field) Solarzelle. Der Grad der Verbesserung ist abhängig vom Verhältnis aus Zellendicke/Diffusionslänge. Es können daher auch billigere Halbleitermaterialien (geringere Diffusionslänge) verwendet und dennoch hohe Wirkungsgrade erreicht werden. Die hier beschriebene Konfiguration ist besonders für den Fall von Vorteil, wenn man aus Kostengründen sowohl die Dicke des Halbleitermaterials als auch dessen Diffusionslänge reduziert.
   Wenn die Zelle von beiden Seiten mit gleicher Intensität beleuchtet wird, so erhält man unabhängig von der Diffusionslänge nahezu die doppelte Ausgangsleistung, da der Wirkungsgrad für Front- und Rückseitenbeleuchtung, abgesehen von der höheren Abschattung auf der Rückseite, gleichgroß ist. Hier unterscheidet sich diese Zelle wesentlich von der unter 1) beschriebenen einseitig Minoritätsträger sammelnden Zelle, bei der das Verhältnis aus Frontseitenwirkungsgrad zu Rückseitenwirkungsgrad sehr stark von der Diffusionslänge des Halbleitermaterials abhängt. Bei Diffusionslängen, die kleiner als die Dicke des Substrates sind, ergibt sich dort ein sehr schlechter Frontseitenwirkungsgrad.
   Die erfindungsgemäßen Rückseitenanordnungen ermöglichen es nun, vorzugsweise zusammen mit der bei der MIS-Inversionsschicht-Solarzelle angewendeten Vorderseitenstruktur mit Hilfe einfacher Niedertemperaturprozesse die doppelseitige Solarzelle zu realisieren.
   Die Funktionsweise dieser beidseitig Minoritätsträger sammelnden Solarzelle ist nun wie folgt:
   Durch das sowohl von der Vorderseite als auch von der Rückseite in den p-Halbleiterkörper einfallende Licht werden Elektron-Loch-Paare erzeugt. Die Löcher wandern zu den Ohmschen Kontakten auf der Rückseite und werden von ihnen gesammelt. Die Elektronen als Minoritätsladungsträger diffundieren nun, je nach dem Ort ihrer Entstehung, entweder zur Vorderseite oder zur Rückseite und gelangen zu den MIS-Kontakten. Vorzugsweise sollen die Minoritätsträger sammelnden Kontaktsysteme von der Vorder- und Rückseite extern miteinander verbunden werden und den einen Pol der Solarzelle bilden. Das rückseitige Majoritätsträger sammelnde Kontaktsystem bildet den anderen Pol. Dies entspricht einer Parallelschaltung der beiden MIS-Diodenanordnungen von Vorder- und Rückseite.

Die doppelseitige Sammlung der Minoritätsladungsträger erlaubt es nun:
a) unter frontseitiger Beleuchtung durch Erhöhung der spektralen Empfindlichkeit im langwelligen Bereich höhere Wirkungsgrade zu erzielen,
b) bei gleicher Dicke des Halbleitersubstrates eine wesentlich kleinere Diffusionslänge und damit billigeres Halbleitermaterial zu verwenden oder es kann bei gleicher Diffusionslänge eine größere Dicke des Halbleiters gewählt und damit mehr Licht absorbiert werden,
c) zusätzlich zu dem erhöhten Wirkungsgrad bei Vorderseitenbeleuchtung im Gegensatz zu bisher bekannten doppelseitig beleuchtbaren Solarzellen auch das von hinten einfallende Licht, abgesehen von der zusätzlichen Abschattung durch die MIS-Kontakte, erheblich besser auszunützen, da die Minoritätsladungsträger nicht erst durch das ganze Halbleitersubstrat zu den sammelnden Kontakten auf der Vorderseite diffundieren müssen (die Abschattung durch die MIS-Kontakte auf der Solarzellenrückseite sollte nicht wesentlich größer als 10% sein, so daß die Gesamtabschattung der Rückseite durch Ohmsche und MIS-Kontakte bei etwa 20% zu liegen kommt),
d) infolge der Reduzierung der Strombelastung der einzelnen MIS-Kontakte und der Inversionsschicht durch die großflächigere doppelseitige Sammlung der Minoritätsladungsträger eine Reduzierung des Serienwiderstandes und damit eine Erhöhung des Füllfaktors und des Wirkungsgrades der Solarzelle zu erreichen. Ferner kann die Dicke der Metallschicht der MIS-Kontakte reduziert werden.

Statt der bei niedrigen Temperaturen hergestellten und mit der Rückseitenanordnung technologisch kompatiblen Vorderseitenanordnung mit MIS-Kontakten und Inversionsschicht kann auch die herkömmliche Anordnung mit ganzflächigem, durch Diffusion oder Ionenimplantation erzeugtem n⁺p- bzw. p⁺n-Übergang und Metall-Kontaktgitter verwendet werden. Bei diesem Solarzellentyp werden demnach die Minoritätsladungsträger teils über den vorderseitigen n⁺p- bzw. p⁺n-Übergang und teils über die rückseitigen Minoritäts-MIS Dioden abgesaugt.

Die Möglichkeit der abgeflachten Pyramiden kann vorteilhafterweise natürlich auch für den als Back-MIS Zelle (R. Hezel and K. Jaeger, J. Electrochem. Soc. 136(2), S.518 (1989) bezeichneten, rückseitig nur die Minoritätsträger sammelnden Solarzellentyp eingesetzt werden. Das Ohmsche Kontaktgitter, das Majoritätsträger sammelt, kann sich mit abgeflachten Pyramiden auf der Vorderseite befinden. Der große Vorteil hierbei ist, daß die Fläche des eigentlichen MIS-Kontaktes auf der Rückseite in Form der abgeflachten Pyramiden sehr klein gemacht werden kann. Die ganzflächige Metallisierung verläuft größtenteils auf der durch die Isolatorschicht sehr gut passivierten Oberfläche. Gleichzeitig stellt die Metallisierung einen hervorragenden rückseitigen Spiegel (BSM "Back Surface Mirror") für das im Halbleiter nicht absorbierte Licht dar.

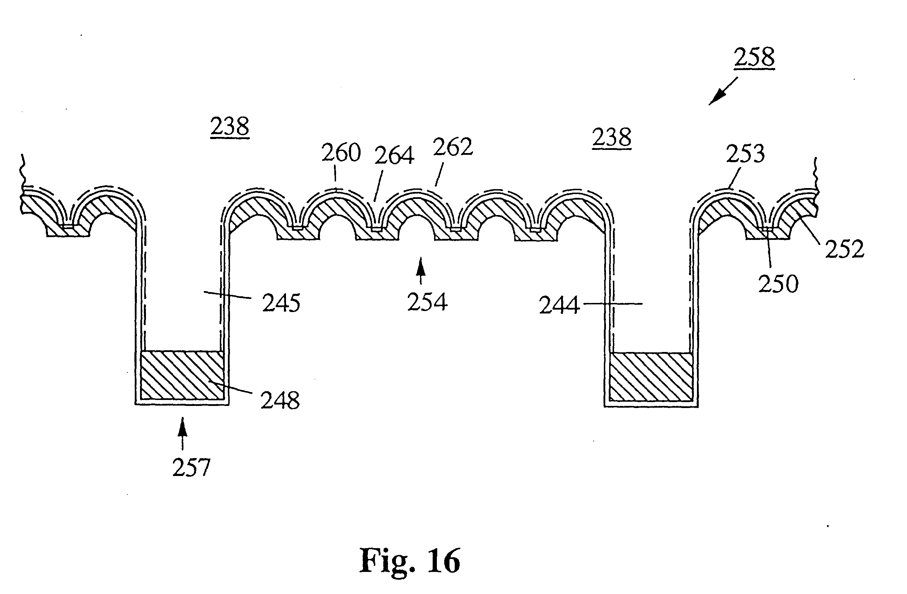

In Fig. 16 ist eine weitere Ausführungsform einer Solarzelle (258) dargestellt, die auf der Rückseite Minoritäts- und Majoritätsladungsträger sammelnde Ohmsche Kontakte (257) bzw. MIS-Kontakte (254) aufweist.

Um die Struktur der Kontakte (254) und (257) zu erreichen, erfolgt das erfindungsgemäße mechanische Bearbeiten mittels vorzugsweise parallel zueinander verlaufender Drähte, die zur Bildung von Rinnen (260) und (262) und damit der zwischen diesen gebildeten Erhebungen (264) den erforderlichen Abstand zueinander und den benötigten Drahtdurchmesser aufweisen.

Im Bereich der Vorsprünge (244) und (245), deren freie äußere Flächen zur Bildung der Ohmschen Kontakte (257) mit der Metallisierung (248) versehen sind, ist Draht ausgespart bzw. der Abstand der Drähte so verändert worden, daß das Halbleitersubstrat (238) in diesen Bereichen nicht abgetragen wird.

Bei dem Ausführungsbeispiel der Rückseite der Solarzelle (258) nach Fig. 16 wird folglich in einem einzigen Arbeitsgang sowohl die Struktur der MIS-Kontakte (254) als auch die Geometrie der Ohmschen Kontakte (257) hergestellt.

Es sei noch erwähnt, daß anstelle der Inversionsschicht (253) auch eine n⁺-Schicht bei einem p-Halbleitersubstrat eingebracht werden kann, wobei die Kontakte zum n⁺ vom MIS-Typ oder als Ohmsche Kontakte ausgebildet sein können.

Auch wenn in den Fig. 12 bis 16 Rückseiten von MIS-Inversionsschicht-Solarzellen (210), (236), (258) dargestellt sind, so kann ein entsprechender Rückseitenaufbau auch für Solarzellen des pn-Typs gewählt werden.

Das erfindungsgemäße Strukturieren vorzugsweise mittels parallel zueinander verlaufender Drähte oder sonstiger mechanischer Strukturierelemente ist selbstverständlich nicht nur auf Halbleitermaterial beschränkt. Vielmehr kann jedwedes im gewünschten Umfang zu strukturierende Material, insbesondere solches, welches im optischen Bereiche benutzt werden soll, erfindungsgemäß bearbeitet werden.

Auch kann - entsprechend der Ausführungsform der Fig. 4 - der Träger der Solarzelle erfindungsgemäß strukturiert werden.

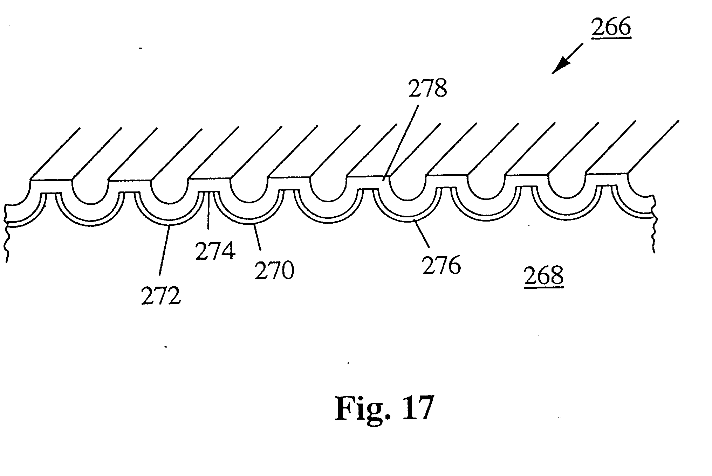

Eine entsprechende Strukturierung erfolgte bei der in Fig. 17 im Ausschnitt dargestellten Solarzelle. So ist ein Trägersubstrat (268) auf mechanischem Weg in zuvor beschriebener Weise, also insbesondere mittels parallel zueinander angeordneter Sägeblätter, Drähte oder auch mittels einer Gattersäge strukturiert worden, um zwischen Gräben (270) und (272) verlaufende Erhebungen (274) zu erzeugen.

Nachdem die Struktur vorliegt, wird die gesamte Oberfläche mit einer Passivierschicht (276) abgedeckt, die als Diffusionsbarriere dient. Als geeignete Materialien sind z.B. Siliziumnitrid oder Aluminiumoxid zu nennen. Die Passivierungsschicht (276) wird sodann im Bereich der Erhebungen (274) durch z.B. Schleifen abgetragen, so daß das Substrat (268) kleinflächig freigelegt ist. Sodann wird auf die strukturierte Oberfläche des Substrats (268) ganzflächig eine Halbleiterschicht (278) abgeschieden, wodurch sich gleichzeitig ein guter kleinflächiger Ohmscher Kontakt mit dem Substrat (268) ausbildet. In den großflächigen übrigen Bereichen ist jedoch eine Reaktion zwischen dem Substratmaterial und dem Halbleiterfilm (278) ausgeschlossen. Dies bedeutet, daß Verunreinigungen in das Halbleitermaterial nicht hineindiffundieren können.

Auf dem Halbleiterfilm (278) kann sodann eine Solarzelle aufgebaut werden, die z.B. der der Fig. 4 entspricht. Selbstverständlich kann auch eine MIS-InversionsschichtSolarzelle auf dem Halbleiterfilm (278) aufgebaut werden.

Ferner ist darauf hinzuweisen, daß bei der Verwendung von einkristallinem Ausgangssubstrat die Möglichkeit besteht, nach Aufbringen der Passivierungsschicht (276) und zumindest teilweisem Abtragen dieser auf den Erhebungen (276) durch Keimbildung in den Öffnungen eine Epitaxieschicht gebildet werden kann. Eine solche Vorgehensweise ist jedoch insbesondere dann von Vorteil, wenn anstelle der linienförmigen Erhebungen eine Pyramidenstruktur vorliegt, so daß die Epitaxieschicht von den Pyramidenspitzen ausgeht.

Aus den zuvor beschriebenen Maßnahmen ergibt sich der Vorteil, daß nur wenige Verunreinigungen aus dem kristallinen, nicht hochwertigen Halbleitermaterial in die Epitaxieschicht diffundieren können, da der größte Teil der Oberfläche des Substrats, vorzugsweise mehr als 95 %, von der Passivierschicht (276) abgedeckt ist.

## Patentansprüche

1. Verfahren zur Herstellung einer Solarzelle (10, 46, 48, 58, 80, 82, 94, 108, 124, 144, 210, 236, 258) umfassend ein Halbleitersubstrat (12, 110, 126, 146, 160, 212, 238), in welchem durch einfallende Strahlungsenergie Ladungsträger erzeugt werden, sowie elektrisch leitende Kontakte (20, 40, 42, 44, 100, 102, 114, 130, 156, 164, 218, 230, 254) zum Ableiten von Ladungsträgern, wobei zur Herstellung der Solarzelle
- auf zumindest einer Halbleitersubstratfläche Erhebungen (24, 26, 28, 116, 118, 136, 138, 148, 150, 168, 220, 222, 224, 240, 242, 274) ausgebildet werden,
- nach Ausbildung der Erhebungen die Halbleitersubstratfläche ganzflächig oder weitgehend ganzflächig mit einer Passivierungsschicht (16, 98, 134, 158, 162, 246, 260) abgedeckt wird,
- von den Erhebungen zumindest teilweise auf diesen vorhandenes Passivierungsmaterial entfernt wird und
- zumindest auf so freigelegte Bereiche der Erhebungen mittelbar oder unmittelbar sowie bereichsweise auf von den Erhebungen ausgehenden Flanken (34, 36, 38) vorhandenem Passivierungsmaterial die elektrisch leitenden Kontakte bildendes Material angeordnet wird,
**dadurch gekennzeichnet,**
- daß die Erhebungen (24, 26, 28, 116, 118, 136, 138, 148, 150, 168, 220, 222, 224, 240, 242, 274) maskierungsfrei durch mechanisches Abtragen und/oder Abätzen von Halbleitermaterial ausgebildet werden und
- daß zumindest das Passivierungsmaterial von den Erhebungen derart abgetragen wird, daß ein plateauartiger Bereich (35, 37, 39, 140) ausgebildet wird, von dessen freier oberen Fläche die Flanken (34, 36, 38) ausgehen und in dem Halbleitermaterial freigelegt verläuft.

2. Verfahren nach Anspruch 1,
**dadurch gekennzeichnet,**
- daß das die elektrisch leitenden Kontakte (20, 40, 42, 44, 100, 102, 114, 130, 156, 164, 218, 230, 254) bildende Material ohne Verwendung einer gesonderten Maske auf dem plateauartigen Bereich der Erhebungen sowie auf zumindest einer von deren Flanken aufgebracht wird.

3. Verfahren nach Anspruch 1,
**dadurch gekennzeichnet,**
daß das Abtragen von zumindest dem Passivierungsmaterial mechanisch und/oder chemisch-mechanisch und/oder durch Ionen-Bombardement und/oder durch Ätzen wie Ionen-, Laser- oder Plasmaätzen erfolgt.

4. Verfahren nach Anspruch 1,
**dadurch gekennzeichnet,**
daß zusammen mit dem Passivierungsmaterial Halbleitermaterial entfernt wird.

5. Verfahren nach Anspruch 1,
**dadurch gekennzeichnet,**
daß die Erhebungen (24, 26, 28, 74, 76, 78, 264, 274) streifenförmig ausgebildet werden, daß auf jede oder nahezu jede der Erhebungen das den elektrisch leitenden Kontakt (20, 40, 42, 44, 100, 102, 114, 130, 156, 164, 218, 230, 254) bildende Material aufgebracht wird und daß die Breite des plateau artigen Bereichs (35, 37, 39, 140) größer als die doppelte Schichtdicke der Passivierungsschicht (16, 98, 134, 158, 162, 246, 276) ist.

6. Verfahren nach Anspruch 1,
**dadurch gekennzeichnet,**
daß großflächig und im wesentlichen gleichzeitig von zumindest mehreren Erhebungen (24, 26, 28, 116, 118, 136, 138, 148, 150, 168, 220, 222, 224, 240, 242, 274) Passivierungsmaterial und gegebenenfalls Halbleitersubstratmaterial im gewünschten Umfang entfernt wird.

7. Verfahren nach Anspruch 1,
**dadurch gekennzeichnet,**
daß das die elektrisch leitenden Kontakte (20, 40, 42, 44, 100, 102, 114, 130, 156, 164, 218, 230, 254) bildende Material zu einer von den plateauartigen Bereichen (35, 37, 39, 140) der Erhebungen (24, 26, 28, 274) aufgespannten Ebene unter einem Winkel α mit 90° > α > 0°, vorzugsweise 30° > α > 1° im Vakuum abgeschieden wird.

8. Verfahren nach Anspruch 1,
**dadurch gekennzeichnet,**
daß das die elektrisch leitenden Kontakte (20, 40, 42, 44, 100, 102, 114, 130, 156, 164, 218, 230, 254) bildende Material elektrolytisch oder durch stromlose Metallisierung abgeschieden wird.

9. Verfahren nach Anspruch 1,
**dadurch gekennzeichnet,**
daß die Erhebungen (24, 26, 28, 74, 76, 78, 116, 118, 136, 138, 148, 150, 168, 220, 222, 224, 240, 242, 274) durch Abtragen von Halbleitermaterial oder eines mit dem Halbleitermaterial zu versehenden Trägers mittels z.B. parallel zueinander angeordneter Sägeblätter oder Drähte, die relativ zu dem Halbleitermaterial bzw. dem Träger bewegt werden, oder mittels Gattersägen ausgebildet werden.

10. Verfahren nach Anspruch 1,
**dadurch gekennzeichnet,**
daß die Passivierungsschicht (16, 98, 134, 158, 162, 246, 260, 276) als Maske für weitere aufzutragende oder auszubildende Schichten, insbesondere für das die elektrisch leitenden Kontakte bildende Material oder zur Diffusion oder Ionenimplantation zur Ausbildung von dotierten Oberflächenschichten im Halbleitersubstrat verwendet wird.

11. Verfahren nach Anspruch 1, unter Verwendung von strukturiertem Trägermaterial (12, 110, 126, 146, 160, 212, 238, 268) für das Halbleitersubstrat,
**dadurch gekennzeichnet,**
daß das Material (12, 110, 126, 146, 160, 212, 238, 268) durch parallel oder im wesentlichen parallel zueinander verlaufende und relativ zum zu strukturierenden Material bewegte mechanische Strukturierungselemente strukturiert wird.

12. Verfahren nach Anspruch 11,
**dadurch gekennzeichnet,**
daß als Strukturierungselement Drähte, Sägeblätter oder eine Gattersäge verwendet werden.

13. Solarzelle (10, 46, 80, 82, 94, 124, 144, 210, 236, 258) umfassend ein Halbleitersubstrat (12, 110, 126, 146, 160, 212, 238), in welchem durch einfallende Strahlungsenergie Ladungsträger erzeugbar sind, die durch ein elektrisches Feld trennbar und sodann über elektrisch leitende Kontakte (20, 40, 42, 44, 100, 102, 114, 130, 156, 164, 218, 230, 254, 257) ableitbar sind, wobei
- zumindest auf einer Halbleitersubstratfläche Flanken (34, 36, 38) aufweisende Erhebungen (24, 26, 28, 116, 118, 136, 138, 148, 150, 168, 220, 222, 224, 240, 242, 274) versehen mit Ladungsträger ableitenden elektrisch leitenden Kontakten ausgebildet sind,
- die Halbleitersubstratfläche zumindest im Bereich zwischen den Kontakten mit einem eine Passivierungsschicht (16, 98, 134, 158, 162, 246, 260, 276) bildenden Passivierungsmaterial abgedeckt ist und
- die Kontakte auf den zuvor von Passivierungsschichtmaterial abgedeckten und sodann von diesem und gegebenenfalls von Halbleitermaterial entfernten Spitzenbereichen der Erhebungen angeordnet sind und sich zumindest bereichsweise über Passivierungsmaterial entlang von Flanken erstrecken,
**dadurch gekennzeichnet,**
daß die Passivierungsschicht (16, 98, 134, 158, 162, 246, 260, 276) im Bereich der Erhebung (24, 26, 28, 116, 118, 136, 138, 148, 150, 168, 220, 222, 224, 240, 242, 274) zumindest bereichsweise Abschnitte eines plateauartig ausgebildeten Bereichs (35, 37, 39, 140) sind, von dem die Flanken (34, 36, 38) ausgehen und in dem Halbleitersubstratmaterial oder eine auf diesem angeordnete Schicht freigelegt verläuft, und daß das den elektrisch leitenden Kontakt (20, 40, 42, 44, 100, 102, 114, 130, 156, 164, 218, 230, 254) bildende Material sich auf dem plateauartigen Bereich und entlang von zumindest einer von diesem ausgehenden Flanke erstreckt.

14. Solarzelle nach Anspruch 13,
**dadurch gekennzeichnet,**
daß die Flanken (34, 36, 38) der Erhebungen (24, 26, 28) zumindest abschnittweise konkav ausgebildet sind.

15. Solarzelle nach Anspruch 13,
**dadurch gekennzeichnet,**
daß der Kontakt (20) entlang freigelegten Halbleitermaterials eine Quererstreckung aufweist, die geringer als entlang der Flanken (34, 36, 38) ist.

16. Solarzelle nach Anspruch 13,
**dadurch gekennzeichnet,**
daß die Erhebungen (24, 26, 28) parallel oder im wesentlichen parallel zueinander verlaufen und vorzugsweise durch rinnenförmige Vertiefungen begrenzt sind.

17. Solarzelle nach Anspruch 13,
**dadurch gekennzeichnet,**
daß die Erhebungen (116, 118, 136, 138, 148, 150, 168, 220, 222, 224, 240, 242) kleinflächig durch von der Halbleitersubstratoberfläche vorspringende Pyramiden bzw. Pyramidenstümpfe, Kegel bzw. Kegelstümpfe oder Säulen gebildet sind.

18. Solarzelle nach Anspruch 13,
**dadurch gekennzeichnet,**
daß die Solarzelle vorder- und rückseitig jeweils parallel zueinander verlaufende Erhebungen bzw. Vertiefungen aufweist, daß die rückseitigen Erhebungen bzw. Vertiefungen einen abweichenden Verlauf zu den vorderseitigen zeigen, wobei vorzugsweise die Erhebungen bzw. Vertiefungen der gegenüberliegenden Seiten der Solarzelle senkrecht oder im wesentlichen senkrecht zueinander verlaufen.

19. Solarzelle nach Anspruch 13,
**dadurch gekennzeichnet,**
daß die Erhebungen (92) und/oder die zwischen diesen verlaufenden rinnenförmigen Vertiefungen in ihren Bodenbereichen texturiert sind.

20. Solarazelle nach Anspruch 13,
**dadurch gekennzeichnet,**
daß der Abstand a zwischen streifenförmig verlaufenden Erhebungen (24, 26) gleich 30µm < a < 2000µm, vorzugsweise 50µm < a < 300µm ist.

21. Solarzelle nach Anspruch 13,
**dadurch gekennzeichnet,**
daß die zwischen den Erhebungen (24, 26, 28) verlaufenden rinnenförmigen Vertiefungen (30, 32) eine Tiefe t mit 25µm<t<200µm aufweisen.

22. Solarzelle nach Anspruch 13,
**dadurch gekennzeichnet,**
daß sich der Abstand a der Erhebungen (24, 26, 28) zur Tiefe t der Vertiefungen (30, 32) verhält wie 10>a/t> 1,5.

23. Solarzelle (210, 236) nach Anspruch 13 mit einem Halbleitersubstrat (212, 238), in welchem durch einfallende Strahlungsenergie Ladungsträger erzeugt werden, die von auf einer Seite des Halbleitersubstrats angeordneten ersten und zweiten Minoritäts- bzw. Majoritätsträger sammelnden Kontakten (218, 230) ableitbar sind,
**dadurch gekennzeichnet,**
daß die ersten und zweiten Kontakte (218, 230) auf einer Erhebungen (220, 222, 224) aufweisenden Halbleitersubstratfläche angeordnet sind, daß die ersten und zweiten Kontakte zumindest bereichsweise auf zuvor mit Passivierungsmaterial abgedeckten und sodann von diesem freigelegten Abschnitten der Erhebungen unmittelbar oder auf einer Isolatorschicht (214) oder auf einer oberflächig dotierten Schicht des Halbleitermaterials angeordnet sind.

24. Solarzelle nach Anspruch 23,
**dadurch gekennzeichnet,**
daß die Erhebungen (220, 222, 224) eine Pyramiden-, Kegel- oder Zylinderform aufweisen oder streifenförmig verlaufen und von parallel oder weitgehend parallel zueinander verlaufenden rinnenförmigen Vertiefungen begrenzt sind.

25. Solarzelle nach Anspruch 23,
**dadurch gekennzeichnet,**
daß die ersten Kontakte Ohmsche Kontakte (218) und die zweiten Kontakte MIS-Kontakte (230) sind und daß der Abstand zwischen einem Ohmschen Kontakt (218) und einem benachbarten MIS-Kontakt geringer als der zwischen zwei benachbarten MIS-Kontakten ist.

26. Solarzelle nach Anspruch 25,
**dadurch gekennzeichnet,**
daß der Abstand zwischen einem MIS-Kontakt (230) und einem Ohmschen Kontakt (218) in etwa die Hälfte des Abstandes von zwei aufeinanderfolgenden MIS-Kontakten ist.

27. Solarzelle nach Anspruch 23,
**dadurch gekennzeichnet,**
daß die äußeren parallel zur Halbleitersubstratfläche verlaufenden freien Flächen der ersten und zweiten Kontakte (218, 230) in oder in etwa einer Ebene verlaufen.

28. Solarzelle (236, 258) nach Anspruch 13 mit einem Halbleitersubstrat (238), in welchem durch einfallende Strahlungsenergie Ladungsträger erzeugt werden, die von auf einer Seite des Halbleitersubstrats angeordneten ersten und zweiten Minoritäts- bzw. Majoritätsträger sammelnden Kontakten (254, 257) ableitbar sind,
**dadurch gekennzeichnet,**
daß sich die ersten elektrisch leitenden Kontakte oder von diesen gebildete Bereiche (254) ganzflächig oder im wesentlichen ganzflächig zwischen den zweiten elektrisch leitenden Kontakten (257) erstrecken und daß die ersten und zweiten elektrischen Kontakte mit ihren freien äußeren Flächen auf unterschiedlichem Niveau verlaufen.

29. Solarzelle nach Anspruch 28,
**dadurch gekennzeichnet,**
daß in Draufsicht der Rückseite der Solarzelle (236) die ersten Kontakte beziehungsweise die von diesen gebildeten Bereiche (254) und die zweiten Kontakte (257) eine geschlossene oder im wesentlichen geschlossene Fläche bilden.

30. Solarzelle nach Anspruch 28,
**dadurch gekennzeichnet,**
daß die ersten elektrisch leitenden Kontakte MIS-Kontakte (254) und die zweiten elektrisch leitenden Kontakte Ohmsche Kontakte (257) sind, die ihrerseits auf erhabenen Bereichen des Halbleitersubstrats angeordnet sind.

31. Solarzelle nach Anspruch 29,
**dadurch gekennzeichnet,**
daß eine Passivierungsschicht (246) die Ohmschen Kontakte (257) abdeckt.

32. Solarzelle nach Anspruch 30,
**dadurch gekennzeichnet,**
daß die Ohmschen Kontakte (257) eine Metallisierung (248) umfaßt, die die Passivierungsschicht (246) zumindest teilweise überdeckt.

33. Solarzelle nach Anspruch 13,
**dadurch gekennzeichnet,**
daß das Halbleitermaterial einkristallin, polykristallin oder amorph und ein Element- oder Verbindungshalbleiter ist.

34. Solarzelle (266) nach Anspruch 13 umfassend ein Halbleitermaterial, in welchem durch einfallende Strahlungsenergie Ladungsträger erzeugbar sind, die durch ein elektrisches Feld trennbar und sodann über elektrisch leitende frontseitige und rückseitige Kontakte ableitbar sind,
**dadurch gekennzeichnet,**
daß der rückseitige Kontakt durch Erhebungen (274) eines Trägersubstrats gebildet ist, daß das Trägersubstrat (268) von einer Passivierungsschicht (276) abgedeckt ist, die im Bereich der Erhebungen entfernt ist, und daß sich über der Passivierungsschicht und den freigelegten Erhebungen das Halbleitermaterial erstreckt.

## Claims

1. A method for manufacturing a solar cell (10, 46, 58, 80, 82, 94, 108, 124, 144, 210, 236, 258) comprising a semiconductor substrate (12, 110, 126, 146, 160, 212, 238) in which charge carriers can be generated by incident radiation energy, and electrically conducting contacts (20, 40, 42, 44, 100, 102, 114, 130, 156, 164, 218, 230, 254) for conducting of charge carriers, in which, for manufacturing said solar cell
- elevated areas (24, 26, 28, 116, 118, 136, 138, 148, 150, 168, 220, 222, 224, 240, 242, 274) are provided on at least one semiconductor substrate surface,
- after formation of said elevated areas said semiconductor substrate surface is completely or largely completely covered with a passivation layer (16, 98, 134, 158, 162, 246, 260),
- passivation material present on said elevated areas is removed at least partially therefrom, and
- material forming said electrically conducting contacts is disposed indirectly or directly at least on the areas of the elevated areas thus exposed and o n some areas on passivation material on flanks extending from the elevared areas,
**wherein**
- said elevated areas (24, 26, 28, 116, 118, 136, 138, 148, 150, 168, 220, 222, 224, 240, 242, 274) are formed without masking by mechanical removal and/or etching off of said semiconductor material and
- at least said passivation material is removed from said elevated areas such that a plateau-like area (35, 37, 39, 140) is formed, from whose free upper surface the flanks (34, 36, 38) extend and in which semiconductor material is exposed.

2. A method according to Claim 1,
**wherein**
- said material forming said electrically conducting contacts (20, 40, 42, 44, 100, 102, 114, 130, 156, 164, 218, 230, 254) is here preferably deposited on said plateau-like area of said elevated areas without using a special mask, and on at least one of their flanks.

3. A method according to Claim 1,
**wherein**
local removal at least of said passivation layer is achieved mechanically and/or chemical-mechanically by ion bombardment and/or by etching such as ion, laser or plasma etching.

4. A method according to Claim 1,
**wherein**
semiconductor material is removed together with said passivation material.

5. A method according to Claim 1,
**wherein**
said elevated areas (24, 26, 28, 74, 76, 78, 264, 274) are designed in strips, the material forming the said electrically conducting contact (20, 40, 42, 44, 100, 102, 114, 130, 156, 164, 218, 230, 254) is deposited on every or on almost every elevated area, and the width of said plateau-like area (35, 37, 39, 140) is greater than double the layer thickness of said passivation layer (16, 98, 134, 158, 162, 246, 276).

6. A method according to Claim 1,
**wherein**
passivation material and if necessary semiconductor substrate material is removed to the required extent over a large surface and substantially simultaneously from at least several elevated areas (24, 26, 28, 116, 118, 136, 138, 148, 150, 168, 220, 222, 224, 240, 242, 274).

7. A method according to Claim 1,
**wherein**
said material forming said electrically conducting contacts (20, 40, 42, 44, 100, 102, 114, 130, 156, 164, 218, 230, 254) is deposited in a vacuum at an angle α with 90° > α > 0°, preferably 30° > α > 1°, in relation to a plane formed by said plateau-like areas (35, 37, 39, 140) of said elevated areas (24, 26, 28, 274).

8. A method according to Claim 1,
**wherein**
said material forming said electrically conducting contacts (20, 40, 42, 44, 100, 102, 114, 130, 156, 164, 218, 230, 254) are deposited electrolytically by currentless metallization.

9. A method according to Claim 1,
**wherein**
said elevated areas (24, 26, 28, 74, 76, 78, 116, 118, 136, 138, 148, 150, 168, 220, 222, 224, 240, 242, 274) are formed by removal of semiconductor material or of a carrier to be provided therewith, by means of, for example, sawblades or wires disposed parallel and moved relative to said semiconductor material or carrier, or by means of gang saws.

10. A method according to Claim 1,
**wherein**
said passivation layer (16, 98, 134, 158, 162, 246, 260, 276) is used as a mask for further layers to be applied or formed, in particular for the material forming the electrically conducting contacts, or for diffusion or ion implantation of doped surface layers in said semiconductor substrate.

11. A method according to Claim 1 by using structured carrier material for the semiconductor substrate, in particular for formation of parallel or substantially parallel elevated areas (24, 26, 28, 274),
**wherein**
said material (12, 110, 126, 146, 160, 212, 238, 268) is structured by mechanical structuring elements parallel or substantially parallel to one another and moved relative to the material to be structured.

12. A method according to Claim 11,
**wherein**
wires, sawblades or a gang saw is used as the structuring element.

13. A solar cell (10, 46, 80, 82, 94, 124, 144, 210, 236, 258) comprising a semiconductor substrate (12, 110, 126, 146, 160, 212, 238) in which charge carriers can be generated by incident radiation energy that are separable by an electrical field and then conductible via electrically conducting contacts (20, 40, 42, 44, 100, 102, 114, 130, 156, 164, 218, 230, 254, 257), where
- elevated areas (24, 26, 28, 116, 118, 136, 138, 148, 150, 168, 220, 222, 224, 240, 242, 274) having flanks (34, 36, 38) provided with electrically conducting contacts conducting charge carriers are formed on at least one semiconductor substrate surface,
- said semiconductor substrate surface is covered with a passivation material forming a passivation layer (16, 98, 134, 158, 162, 246, 260, 276) at least in the area between said contacts, and
- said contacts are disposed on the tip areas of said elevated areas previously covered by said passivation layer material and then freed of this and if necessary of semiconductor material, and extend at least in some areas over passivation material along flanks,
**wherein**
said passivation layer (16, 98, 134, 158, 162, 246, 260, 276) in the area of said elevated areas (24, 26, 28, 116, 118, 136, 138, 148, 150, 168, 220, 222, 224, 240, 242, 274) is at least in some areas sections of a plateau-like area (35, 37, 39, 140) from which said flanks (34, 36, 38) extend and in which semiconductor substrate material or a layer disposed thereon is provided, and wherein said material forming said electrically conducting contact (20, 40, 42, 44, 100, 102, 114, 130, 156, 164, 218, 230, 254) extends over said plateau-like area and along at least one flank extending therefrom.

14. A solar cell according to Claim 13,
**wherein**
said flanks (34, 36, 38) of said elevated areas (24, 26, 28) are formed concave at least in some areas.

15. A solar cell according to Claim 13,
**wherein**
said contact (20) along exposed semiconductor material has a transverse extent that is lower than along said flanks (34, 36, 38).

16. A solar cell according to Claim 13,
**wherein**
said elevated areas (24, 26, 28) are parallel or substantially parallel and are preferably limited by flute-shaped grooves.

17. A solar cell according to Claim 13,
**wherein**
said elevated areas (116, 118, 136, 138, 148, 150, 168, 220, 222, 224, 240, 242, 274) are formed with small surfaces by pyramids or truncated pyramids, cones or truncated cones or columns projecting from the semiconductor substrate surface.

18. A solar cell according to Claim 13,
**wherein**
said solar cell has on its front and back surfaces elevated areas or grooved areas parallel to one another, wherein said back surface elevated areas or grooved areas have a different pattern to those on the front surface, with said elevated areas or grooved areas of the opposite surfaces preferably being vertical or substantially vertical to one another.

19. A solar cell according to Claim 13,
**wherein**
said elevated areas (92) and/or said flute-shaped grooved areas running between them are textured over their bottom areas.

20. A solar cell according to Claim 13,
**wherein**
the spacing a between strip-like elevated areas (24, 26) is 30 µm < a < 2000 µm, preferably 50 µm < a < 300 µm.

21. A solar cell according to Claim 13,
**wherein**
said flute-shaped grooved areas (30, 32) between said elevated areas (24, 26, 28) have a depth t of 25 µm < t < 200 µm.

22. A solar cell according to Claim 13,
**wherein**
the spacing a of said elevated areas (24, 26, 28) in relation to the depth t of said grooved areas (30, 32) is 10 > a/t > 1.5.

23. A solar cell (210, 236) according to Claim 13 having a semiconductor substrate (212, 238) in which charge carriers can be generated by incident radiation energy that are conductible by first and second contacts (218, 230) disposed on one side of said semiconductor substrate and collecting minority and majority carriers respectively,
**wherein**
said first and second contacts (218, 230) are disposed on a semiconductor substrate having elevated areas (220, 222, 224), said first and second contacts are disposed at least in some areas on sections of said elevated areas previously covered with passivation material and then cleared thereof or on an insulating layer (214) or on a surface-doped layer of said semiconductor material.

24. A solar cell according to Claim 23,
**wherein**
said elevated areas (220, 222, 224) have a pyramidal, conical or cylindrical form or are disposed in strips, and are limited by parallel or substantially parallel flute-shaped grooved areas.

25. A solar cell according to Claim 23,
**wherein**
said first contacts are ohmic contacts (218) and said second contacts are MIS contacts (230), and the spacing between an ohmic contact (218) and an adjacent MIS contact is lower than that between two adjacent MIS contacts.

26. A solar cell according to Claim 25,
**wherein**
the spacing between an MIS contact (230) and an ohmic contact (218) is approximately half the spacing between two consecutive MIS contacts.

27. A solar cell according to Claim 23,
**wherein**
the external free surfaces, parallel to said semiconductor substrate, of said first and second contacts (218, 230) are in or approximately in a single plane.

28. A solar cell (236, 258) according to Claim 13 having a semiconductor substrate (238) in which charge carriers can be generated by incident radiation energy that are conductible by first and second contacts (254, 257) disposed on one side of said semiconductor substrate and collecting minority and majority carriers respectively,
**wherein**
said first electrically conducting contacts or areas (254) formed thereby extend over the full surface or substantially over the surface area between said second electrically conducting contacts 257), and said first and second electrical contacts run with their free external surfaces on different levels.

29. A solar cell according to Claim 28,
**wherein**
said first contacts or said areas (254) formed thereby and said second contacts (257) form in a plan view of the back surface of said solar cell (236) a closed or substantially closed surface.

30. A solar cell according to Claim 28,
**wherein**
said first electrically conducting contacts are MIS contacts (254) and said second contacts ohmic contacts (257), which in turn are disposed on raised areas of said semiconductor substrate.

31. A solar cell according to Claim 29,
**wherein**
a passivation layer (246) covers said ohmic contacts (257).

32. A solar cell according to Claim 30,
**wherein**
said ohmic contacts (257) are surrounded by a metal layer (248) that at least partially covers the passivation layer (246).

33. A solar cell according to Claim 13,
**wherein**
the semiconductor material is monocrystalline, polycrystalline or amorphous and is an elemental or compound semiconductor.

34. A solar cell (266) according to Claim 13 comprising a semiconductor material in which charge carriers can be generated by incident radiation energy that are separable by an electrical field and then conductible via electrically conducting front surface and rear surface contacts,
**wherein**
said back surface contact is formed by elevated areas (274) of a carrier substrate, said carrier substrate is covered by a passivation layer (276) removed in the area of said elevated areas, and the semiconductor material extends over said passivation layer and said exposed elevated areas.

## Revendications

1. Procédé de fabrication d'une cellule photovoltaïque (10, 46, 48, 58, 80, 82, 94, 108, 124, 144, 210, 236, 258), comprenant un substrat semi-conducteur (12, 110, 126, 146, 160, 212, 238), dans lequel la lumière solaire incidente crée des porteurs de charge, ainsi que des contacts électriques (20, 40, 42, 44, 100, 102, 114, 130, 156, 164, 218, 230, 254), permettant d'évacuer ces porteurs de charge, ledit procédé comprenant:
- la formation de saillies (24, 26, 28, 116, 118, 136, 138, 148, 150, 168, 220, 222, 224, 240, 242, 274) sur au moins une face du substrat semi-conducteur,
- le masquage de ladite face du substrat semi-conducteur à part entière ou pour l'essentiel entière au moyen d'une couche de passivation (16, 98, 134, 158, 162, 246, 260) après formation desdites saillies,
- l'enlèvement au moins partiel de ce matériau de passivation sur ces saillies,
- l'application directe ou indirecte d'un matériau conducteur, formant contact électrique, sur au moins les zones ainsi mises à nu des saillies, ou partiellement sur le matériau de passivation recouvrant les flancs (34, 36, 38) des saillies,
caractérisé en ce que
- lesdites saillies (24, 26, 28, 116, 118, 136, 138, 148, 150, 168, 220, 222, 224, 240, 242, 274) sont formées sans masquage par enlèvement mécanique et/ou décapage du matériau semi-conducteur, et en ce qu'au moins le matériau de passivation est enlevée des sommets des saillies de manière telle que des zones en forme de plateau (35, 37, 39, 140) se forment, dont la surface supérieure libre constitue le point de départ des flancs (34, 36, 38), et à l'intérieur desquelles le matériau semi-conducteur se trouve à nu.

2. Procédé selon revendication 1
**caractérisé en ce que**
ledit matériau formant les contacts électriques (20, 40, 42, 44, 100, 102, 114, 130, 156, 164, 218, 230, 254) est appliqué sur les zones en forme de plateau des saillies, ainsi que sur au moins un de leurs flancs, sans utilisation d'un masque particulier.

3. Procédé selon revendication 1
**caractérisé en ce que**
l'enlèvement au moins du matériau de passivation est réalisé par des moyens mécaniques et/ou chimico-mécaniques, et/ou par bombardement à ions et/ou par décapage, tel que le décapage à ions, à laser ou à plasma.

4. Procédé selon revendication 1
**caractérisé en ce que**
du matériau semi-conducteur est enlevé conjointement avec ledit matériau de passivation.

5. Procédé selon revendication 1
**caractérisé en ce que**
lesdites saillies (24, 26, 28, 74, 76, 78, 264, 274) sont réalisées en forme de bandes, et en ce que ledit matériau formant les contacts électriques (20, 40, 42, 44, 100, 102, 114, 130, 156, 164, 218, 230, 254) est appliqué sur chacune ou presque toutes les saillies, et en ce que la largeur de ladite zone en forme de plateau (35, 37, 39, 140) est plus grande que le double de l'épaisseur de ladite couche de passivation (16, 98, 134, 158, 162, 246, 276).

6. Procédé selon revendication 1
**caractérisé en ce que**
ledir matériau de passivation, et éventuellement ledit matériau semi-conducteur, sont enlevés d'au moins plusieurs desdites saillies (24, 26, 28, 116, 118, 136, 138, 148, 150, 168, 220, 222, 224, 240, 242, 274) par grande étendue, au volume souhaitée et pour l'essentiel simultanément.

7. Procédé selon revendication 1
**caractérisé en ce que**
ledit matériau formant les contacts électriques (20, 40, 42, 44, 100, 102, 114, 130, 156, 164, 218, 230, 254) est déposé dans le vide sur le plan formé par lesdites zones en forme de plateau (35, 37, 39, 140) desdites saillies (24, 26, 28, 274) selon un angle α de façon à ce que 90° < α < 0° et de préférence à ce que 30° < α < 1°.

8. Procédé selon revendication 1
**caractérisé en ce que**
ledit matériau formant les contacts électriques (20, 40, 42, 44, 100, 102, 114, 130, 156, 164, 218, 230, 254) est déposé par un procédé électrolytique ou une métallisation sans courant.

9. Procédé selon revendication 1
**caractérisé en ce que**
lesdites saillies (24, 26, 28, 74, 76, 78, 116, 118, 136, 138, 148, 150, 168, 220, 222, 224, 240, 242, 274) sont formées par enlèvement du matériau semi-conducteur ou du matériau porteur dudit matériau semi-conducteur par exemple à l'aide de plusieurs lames de scie ou de fils-scies parallèles, animés d'un mouvement relatif par rapport au matériau semi-conducteur, ou à l'aide d'une scie multilame alternative.

10. Procédé selon revendication 1
**caractérisé en ce que**
ladite couche de passivation (16, 98, 134, 158, 162, 246, 260, 276) est utilisée comme masque pour les autres couches à déposer ou à former, notamment pour le matériau formant les contacts électriques ou pour la diffusion ou l'implantation d'ions en vue de former des couches de surface dopées dans ledit substrat semi-conducteur.

11. Procédé selon revendication 1 utilisant un matériau porteur structuré (12, 110, 126, 146, 160, 212, 238, 268) pour le substrat semi-conducteur
**caractérisé en ce que**
ledit matériau (12, 110, 126, 146, 160, 212, 238, 268) est structuré à l'aide d'éléments de structuration parallèles, ou pour l'essentiel parallèles, animés d'un mouvement relatif par rapport au matériau à structurer.

12. Procédé selon revendication 11
**caractérisé en ce que**
lesdits éléments de structuration sont des fils-scies, des lames de scie ou une scie multilame alternative.

13. Cellule photovoltaïque (10, 46, 80, 82, 94, 124, 144, 210, 236, 258), comprenant un substrat semi-conducteur (12, 110, 126, 146, 160, 212, 238), dans lequel une énergie de rayonnement incidente peut créer des porteurs de charge qui peuvent à leur tour être séparés à l'aide d'un champ électrique et évacués via des contacts électriques (20, 40, 42, 44, 100, 102, 114, 130, 156, 164, 218, 230, 254, 257) et dans laquelle:
- sur au moins une face dudit substrat semi-conducteur sont formées des saillies (24, 26, 28, 116, 118, 136, 138, 148, 150, 168, 220, 222, 224, 240, 242, 274), possédant des flancs (34, 36, 38), et dotées à leur tour de contacts électriques afin d'évacuer les porteurs de charge,
- ladite face du substrat semi-conducteur est recouverte au moins dans la zone entre les contacts par un matériau de passivation formant une couche de passivation (16, 98, 134, 158, 162, 246, 260, 276),
- les contacts sont disposés sur les sommets desdites saillies, recouvertes d'abord de matériau de passivation et ensuite libérées de ce matériau et éventuellement aussi de matériau semi-conducteur, ces contacts s'étendant au moins à l'intérieur de certaines zones sur ledit matériau de passivation le long de flancs,
**caractérisée en ce que**
lesdites couches de passivation (16, 98, 134, 158, 162, 246, 260, 276) dans la zone desdites saillies (24, 26, 28, 116, 118, 136, 138, 148, 150, 168, 220, 222, 224, 240, 242, 274) sont au moins dans certaines parties des sections de zones en forme de plateau (35, 37, 39, 140), desquelles partent lesdits flancs (34, 36, 38) et dans lesquels le matériau semi-conducteur ou la couche le recouvrant se trouvent à nu, et en ce que le matériau formant les contacts électriques (20, 40, 42, 44, 100, 102, 114, 130, 156, 164, 218, 230, 254) se trouve sur ladite zone en forme de plateau et au moins sur un des flancs partant de celle-ci,

14. Cellule photovoltaïque selon revendication 13
**caractérisée en ce que**
lesdits flancs (34, 36, 38) desdites saillies (24, 26, 28) sont formés de manière concave au moins dans certaines parties.

15. Cellule photovoltaïque selon revendication 13
**caractérisée en ce que**
ledit contact (20) le long du matériau semi-conducteur mis à nu présente une dimension transversale qui est inférieure à celle le long desdits flancs (34, 36, 38).

16. Cellule photovoltaïque selon revendication 13
**caractérisée en ce que**
lesdites saillies (24, 26, 28) sont parallèles, ou pour l'essentiel parallèles, et sont limitées de préférence par des cavités en forme de rainure.

17. Cellule photovoltaïque selon revendication 13
**caractérisée en ce que**
lesdites saillies (116, 118, 136, 138, 148, 150, 168, 220, 222, 240, 242) de petit format sont formées par des pyramides ou des troncs de pyramide, des cônes ou des troncs de cône ou des colonnettes saillants de la surface du substrat semi-conducteur.

18. Cellule photovoltaïque selon revendication 13
**caractérisée en ce que**
ladite cellule photovoltaïque présente sur la face avant et arrière des saillies ou des cavités disposées de manière parallèle et de façon telle que les saillies ou cavités sur la face arrière suivent une direction différente de celles de la face avant et dans laquelle les saillies ou cavités des faces opposées suivent une direction perpendiculaire ou pour l'essentiel perpendiculaire.

19. Cellule photovoltaïque selon revendication 13
**caractérisée en ce que**
lesdites saillies (92) et/ou lesdites cavités en forme de rainure se trouvant entre celles-ci sont texturées à leur fond.

20. Cellule photovoltaïque selon revendication 13
**caractérisée en ce que**
la distance a séparant lesdites saillies (24, 26) en forme de bande est de 30 µm < a < 2000 µm, et de préférence de 50 µm < a < 300 µm.

21. Cellule photovoltaïque selon revendication 13
**caractérisée en ce que**
la profondeur t desdites cavités (30, 32) en forme de rainure séparant lesdites saillies (24, 26, 28) est de 25 µm < t < 200 µm.

22. Cellule photovoltaïque selon revendication 13
**caractérisée en ce que**
le rapport a/t entre la distance a séparant lesdites saillies (24, 26, 28) et la profondeur t desdites cavités (30, 32) est de 10 > a/t > 1,5.

23. Cellule photovoltaïque (210, 236) selon revendication 13, comprenant un substrat semi-conducteur (212, 238), dans lequel une énergie de rayonnement incidente peut créer des porteurs de charge qui peuvent être évacués à leur tour par des premiers et seconds contacts (218, 230) recueillant les porteurs minoritaires et majoritaires
**caractérisée en ce que**
lesdits premiers et seconds contacts (218, 230) sont disposés sur une face du substrat semi-conducteur comportant lesdites saillies (220, 222, 224), et en ce que lesdits premiers et seconds contacts sont disposés au moins dans certaines zones sur des parties des saillies d'abord recouvertes par du matériau de passivation, puis libérées de ce matériau de passivation, et y sont disposées soit directement, soit sur une couche d'isolement (214), soit sur une couche du matériau semi-conducteur dopée en surface.

24. Cellule photovoltaïque selon revendication 23
**caractérisée en ce que**
lesdites saillies (220, 222, 224) possèdent la forme d'une pyramide, d'un cône ou d'un cylindre ou qu'elles sont disposées en bande et sont alors limitées par des cavités en forme de rainure, disposées en parallèle ou pour l'essentiel en parallèle.

25. Cellule photovoltaïque selon revendication 23
**caractérisée en ce que**
lesdits premiers contacts (218) sont des contacts ohmiques et que les seconds contacts (230) sont des contacts MIS et que la distance séparant un contact ohmique (218) du contact MIS avoisinant est inférieure à celle entre deux contacts MIS avoisinants.

26. Cellule photovoltaïque selon revendication 25
**caractérisée en ce que**
la distance séparant un contact MIS (230) d'un contact ohmique (218) est environ la moitié de la distance séparant deux contacts MIS avoisinants.

27. Cellule photovoltaïque selon revendication 23
**caractérisée en ce que**
les surfaces extérieures libres desdits premiers et seconds contacts (218, 230) et se trouvant en parallèle à la face dudit substrat semi-conducteur, sont disposées dans un même plan ou approximativement dans un plan.

28. Cellule photovoltaïque (236, 258) selon revendication 13, comprenant un substrat semi-conducteur (238), dans lequel une énergie de rayonnement incidente peut créer des porteurs de charge qui peuvent être évacués à leur tour par des premiers et seconds contacts (254, 257) recueillant les porteurs minoritaires et majoritaires
**caractérisée en ce que**
lesdits premiers contacts électriques ou les zones (254) formées par ces contacts, sont disposés entièrement, ou pour l'essentiel entièrement, entre lesdits seconds contacts électriques (257), et en ce que ces premiers et seconds contacts électriques se trouvent à différents niveaux avec leurs surfaces extérieures libres.

29. Cellule photovoltaïque selon revendication 28
**caractérisée en ce que**
lesdits premiers contacts électriques ou les zones (254) formées par ces contacts ainsi que lesdits seconds contacts (257) forment une aire fermée, ou pour l'essentiel fermée, en regardant sur la face arrière (236) de ladite cellule photovoltaïque.

30. Cellule photovoltaïque selon revendication 28
**caractérisée en ce que**
lesdits premiers contacts électriques sont des contacts MIS (254) et que lesdits seconds contacts électriques sont des contacts ohmiques (257), disposés à leur tour sur des zones en saillie dudit substrat semi-conducteur.

31. Cellule photovoltaïque selon revendication 29
**caractérisée en ce que**
une couche de passivation (246) recouvre lesdits contacts ohmiques (257).

32. Cellule photovoltaïque selon revendication 30
**caractérisée en ce que**
lesdits contacts ohmiques (257) comprennent une métallisation (248) qui recouvre au moins en partie ladite couche de passivation (246).

33. Cellule photovoltaïque selon revendication 13
**caractérisée en ce que**
le matériau semi-conducteur est monocristallin, polycristallin ou amorphe et qu'il est un semi-conducteur élémentaire ou composé.

34. Cellule photovoltaïque (266) selon revendication 13, comprenant un substrat semi-conducteur, dans lequel une énergie de rayonnement incidente peut créer des porteurs de charge qui peuvent être séparés à leur tour par un champ électrique puis évacués par des contacts électriques sur la face avant et sur la face arrière
**caractérisée en ce que**
ledit contact sur la face arrière est formé par des saillies (274) du substrat porteur, et en ce que ce substrat porteur (268) est recouvert d'une couche de passivation (276) qui a été enlevée dans la zone desdites saillies, et en ce que le matériau semi-conducteur est disposé sur ladite couche de passivation et les saillies mises à nu.
